(19) Europäisches Patentamt
European Patent Office
Office européen des brevets

(11) **EP 3 336 919 B1**

(12) **EUROPEAN PATENT SPECIFICATION**

(45) Date of publication and mention of the grant of the patent:
**22.02.2023 Bulletin 2023/08**

(21) Application number: **17183573.9**

(22) Date of filing: **27.07.2017**

(51) International Patent Classification (IPC):
***H01L 51/56*** *(2006.01)* ***H01L 51/40*** *(2006.01)*
***H01L 51/48*** *(2006.01)* ***H01L 27/32*** *(2006.01)*

(52) Cooperative Patent Classification (CPC):
**H01L 27/3246; H01L 51/0015;** H01L 27/3283; H01L 51/0504; H01L 51/42; H01L 51/5088; Y02E 10/549

(54) **METHOD FOR PREPARING AN ORGANIC ELECTRONIC DEVICE, ORGANIC ELECTRONIC DEVICE, AND A DEVICE COMPRISING THE SAME**

VERFAHREN ZUR HERSTELLUNG EINER ORGANISCHEN ELEKTRONISCHEN VORRICHTUNG, ORGANISCHE ELEKTRONISCHE VORRICHTUNG UND VORRICHTUNG DAMIT

PROCÉDÉ DE PRÉPARATION D'UN DISPOSITIF ÉLECTRONIQUE ORGANIQUE, DISPOSITIF ÉLECTRONIQUE ORGANIQUE ET DISPOSITIF LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2016 EP 16203671**

(43) Date of publication of application:
**20.06.2018 Bulletin 2018/25**


(73) Proprietor: **Novaled GmbH**
**01099 Dresden (DE)**

(72) Inventors:
- **Furno, Mauro**
  **01307 Dresden (DE)**
- **Langguth, Oliver**
  **01307 Dresden (DE)**
- **Canzler, Tobias**
  **01307 Dresden (DE)**

(74) Representative: **Bittner, Thomas L.**
**Boehmert & Boehmert**
**Anwaltspartnerschaft mbB**
**Pettenkoferstrasse 22**
**80336 München (DE)**



(56) References cited:
**WO-A1-2012/133203** **JP-A- 2002 110 345**
**JP-B2- 3 849 726** **US-A1- 2013 295 715**
**US-A1- 2016 211 461**

- **PARISSE P ET AL: "Conductivity of the thin film phase of pentacene", ORGANIC ELECTRONICS, ELSEVIER, AMSTERDAM, NL, vol. 7, no. 5, 6 June 2006 (2006-06-06), pages 403-409, XP024972799, ISSN: 1566-1199, DOI: 10.1016/J.ORGEL.2006.05.002 [retrieved on 2006-10-01]**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).


EP 3 336 919 B1

## Description

The present invention relates to a method for preparing an organic electronic device, an organic electronic device obtainable this way and a device, such as a display device, comprising the organic electronic device.

In organic electronic devices, cross-talk is a phenomenon by which a signal transmitted to one circuit or device creates an undesired effect in neighboring circuit or device. Cross-talk is usually caused by undesired capacitive, inductive or conductive coupling between neighboring circuit or device elements, or part of a circuit or device element. In organic electronic devices, wherein the distance is small between circuits or device elements, for example high-resolution display screens, high resolution active matrix organic electronic diode (AMOLED) displays, thin-film transistor (TFT) arrays, photodetector arrays and image sensors, the phenomenon of cross-talk may be particularly prominent. The root cause may be a conductive path between neighboring circuits or device elements brought about by common conductive layers or materials used in the device array.

For example, common conductive layers may be charge injection layers on the electrodes or conductive layers in charge generation layers (CGLs). Such conductive injection layer can be shared between several, if not all, pixels of a device and is therefore called a "common" conductive layer. Thus, an electrical current can flow through the common conductive layer from an addressed pixel to adjacent pixels which are not addressed. This causes the undesired effect that the adjacent pixels light up although they are not switched on. The common conductive layer in organic electronic devices may be a redox-doped charge transport or charge generation layer.

## DESCRIPTION OF RELATED PRIOR ART

Several methods to reduce cross-talk are described in the related prior art. For example, OLED displays are produced industrially on large scale by vacuum deposition of organic functional materials, most commonly the emissive layer, through fine-metal masks (FMM) onto common conductive layers or charge transport layers (US2008100204). FMM might be applied to separate all functional organic layers in OLEDs of a display device, which may reduce the likelihood of electrical cross-talk to occur. Other methods of spatially separating circuit or device elements are micro- and nano-patterning techniques. These methods have the disadvantage of being expensive and time-consuming.

Reducing the thickness of the common conductive layers to a minimum of <10nm can reduce the cross-talk phenomenon but is often at the expense of device performance. Another option is the increase of distance between the circuits or device elements. However, this is contradicting the electronics industry's ambition for higher device density and resolution.

Scanning beam methods may be used to selectively annihilate common conductive layers between neighboring circuits or device elements. Especially for large area applications these techniques are too time-consuming.

US 2013/295715 A1 discloses a method for etching with a laser beam having a predetermined wavelength an area of a layer of a first material, said area being deposited at the surface of at least two second materials, includes: depositing a layer of a third material on the layer of the first material, the first and the third materials having a chemical affinity on application of the laser beam greater than the chemical affinity during said application between the first material and each of said at least two second materials; and applying the laser beam to an area of a free surface of the layer of third material vertically above the area of the layer of first material with a fluence of said laser beam causing the separation of said area.

Parisse et al. Organic electronics, 2006, 7(5), 403 - 409 discloses an investigation on the morphological, structural and transport properties of pentacene thin films (20 nm) grown by high vacuum thermal evaporation on patterned substrates with different interelectrodes distances.

WO 2012/133203 A1 discloses a method for forming a vapor deposition film pattern with: a step for forming a heat-generating layer on a region (R3) not requiring vapor deposition in a substrate (20) on which a film is to be formed; a step for forming the vapor deposition film on the film formation surface of the substrate (20) on which the film is to be formed so as to cover at least a part of the heat-generating layer, said film formation surface containing the region (R3) not requiring vapor deposition; and a step for selectively removing the vapor deposition film formed on the region (R3) not requiring vapor deposition by converting the film into a gas by causing the generation of heat from the heat-generating layer so that the heat generated has at least the temperature required for the vapor deposition film that is to be removed to be converted into a gas.

US 2016/211 461 A1 discloses electronic and optoelectronic devices that may include at least one inorganic surface covered at least partly by an organic layer. The organic layer may include a compound having at least one anchor group anchoring the compound to the inorganic surface, at least one functional moiety, and at least one methylidenyl group. Compounds and methods for manufacturing electronic and optoelectronic devices are also provided.

JP 3 849726 B2 discloses a manufacturing process of an organic electroluminescence element capable of accurately forming the organic electroluminescence element having a fine element pattern.

JP 2002 110345 A discloses a manufacturing method of a mask and an organic EL display element. In the

method a stripe shape shadow mask is used in laminating the organic luminous layers 7R, 7G, 7B. By irradiating a laser beam, the organic luminous layers 7R, 7G, 7B are cut for each picture element.

SUMMARY OF INVENTION

Therefore, it is, in light of the prior art, the object of the present invention to provide a method for preparing an organic electronic device as well as respective organic electronic devices which may comprise an array of neighboring circuits or device elements overcoming drawbacks of the prior art. In particular, a method for preparing an organic electronic device shall be provided for reducing electrical cross-talk between neighboring electrode areas comprised in the organic electronic device. The method shall be inexpensive, suitable for mass production and suitable to achieve excellent device performance.

This object is achieved in accordance with the independent claims. Further embodiments result from the sub-claims.

This object has first of all been achieved by a method for preparing an organic electronic device comprising the steps:

a) providing a layer stack applicable for preparing the organic electronic device, the layer stack comprising:

aa) a light absorption layer; and

bb) an organic semiconductor layer having a conductivity of at least $10^{-7}$ S/cm and a thickness of 0.1 to 100 nm;

wherein the distance between the organic semiconductor layer and the light absorption layer is selected from 0 to 500 nm;

b) providing a light source;

c) reducing the conductivity of the organic semiconductor layer by an irradiation treatment of the light absorption layer by exposing it to light from the light source;

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack of at least 1 $cm^2$, preferably at least 100 $cm^2$; and

the duration of the irradiation treatment is 10 ms or less and the energy density of the irradiation treatment is from 0.1 to 20 $J/cm^2$ at the position of the light absorption layer.

The distance between the organic semiconductor layer and the light absorption layer is measured from the surface of the light absorption layer facing the organic semiconductor layer to the surface of the organic semiconductor layer facing the light absorption layer, in the direction of the beam of the light source. Preferably, the beam of the light source is arranged in such a way, that the beam strikes the layer stack at a 90 degree angle relative to the plane formed by the layer stack.

The distance between the organic semiconductor layer and the light absorption layer of not more than 500 nm ensures thermal contact between the organic semiconductor layer and the light absorption layer. Without being bound by theory, the beneficial effect of the present invention may be attributed to the fact that the irradiation energy absorbed by the light absorption layer may be at least partially converted to thermal energy in the irradiated sections of the light absorption layer. Thermal energy may be transferred from the light absorption layer to the organic semiconductor layer, which may result in reduced conductivity. Surprisingly, it was found that the conductivity of the organic semiconductor layer in areas which are not arranged in a distance of 0 to 500 nm from the light absorption layer is essentially unchanged compared to the conductivity prior to irradiation treatment. Thereby, good performance of the organic electronic device is retained in the areas where high conductivity of the organic semiconductor layer is desirable.

In another embodiment, the distance between the organic semiconductor layer and the light absorption layer is selected between 0 and 250 nm, preferably between 0 and 50 nm, also preferred between 0 and 40 nm.

In another embodiment, the distance between the organic semiconductor layer and the light absorption layer is 0 nm.

In the context of the present specification, the term organic in "organic semiconductor layer" means a layer which comprises or consists of organic compounds, i.e. containing (mainly) the elements C, H, O, N, S, and F.

In the context of the present specification, the term "light" means electromagnetic radiation with a wavelength of 300 and 1000 nm.

In the context of the present specification, the term "uniform" means irradiation energy which differs by less than 50 % between the center and the edges of a surface area of the layer stack, preferably less than 30%, also preferred less than 20%.

In the context of the present specification, the term "light absorption layer" means a layer which absorbs light between 300 and 1000 nm.

In the context of the present specification, absorption means the proportion of the total energy emitted by the light source which is absorbed by a layer. The characterization of absorption of the layer requires first the experimental measurement of the spectrally resolved absorption coefficient of the layer. The absorption coefficient is obtained as follows

- The layer is formed on a glass substrate, with typical thickness of 1 mm or less, by thermal evaporation or solution coating, for example spin-coating, dip-coating, printing.
- A spectrometer, for example Shimadzu UV-1800 (manufactured by Shimadzu Corporation, Kyoto, Japan), is used to measure the spectrally resolved reflection and transmission of the system composed by the layer and the carrier substrate (Rs and Ts, respectively)
- The spectrometer is also used to measure the spectrally resolved reflection and transmission of the layer of the blank substrate (Rso and Tso, respectively)
- The spectrally resolved absorption of the layer is extracted as As = 1 - Rs - Ts/Tso

The total absorption of the layer is calculated as an integral over wavelength of the spectral absorption As multiplied by the spectrally resolved spectrum of the radiation emitted by the light source Is:

$$A = \int As(\lambda) * Is(\lambda) * d\lambda$$

In above mathematical formula, Is denotes the spectral energy per unit wavelength of the light source used in the treatment. Typical range of emission for white light sources is from ultraviolet to infrared, for example 300 nm to 1000 nm.

In another embodiment, the absorption of the light absorption layer with respect to the light irradiated from the light source is at least 5 times higher than the respective absorption of the organic semiconductor layer, preferably 10 times higher.

In a further embodiment, the absorption layer has a total absorption with respect to the light irradiated from the light source which is higher than the respective total absorption of the remaining layer stack.

In another embodiment, the organic semiconductor layer has an absorption of 20 % or less, preferably 10 % or less, with respect to the light irradiated from the light source.

If the absorption is selected in this range, the method may be particularly suitable to lower conductivity of the organic semiconductor layer in the areas arranged in a distance of 0 to 500 nm from the light absorption layer.

The inventive "layer stack applicable for preparing the organic electronic device" shall be understood as a part of a respective layered organic electronic device known in the art.

In a further embodiment, the organic semiconductor layer is arranged between the light source and the light absorption layer.

In one embodiment, the energy density of the light treatment is from 1 to 10 J/cm$^2$.

In a further embodiment, the light source is selected from a gas discharge lamp, preferably xenon light source, or an LED light source or a laser light source.

In another embodiment, the irradiation treatment may comprise exposure of the light absorption layer to a single light pulse or multiple light pulses.

In a further embodiment, the light source may be a flash lamp. The flash lamp may be a Xenon or LED light source or a Laser source suitable for irradiation treatment of an area of > 1 cm$^2$ with one radiation pulse.

The flash lamp may be a Fluid cooled Xenon flash Lamp part P3775 as available from Heraeus Noblelight Ltd, Cambridge, UK.

If the light source is selected in this way, an area can be treated which is larger than when using state of the art methods of irradiation treatment, for example laser scanning. Thereby, a substantial increase in TACT time may be

achieved during mass production of organic electronic devices.

In a further embodiment, the layer stack may further comprise at least one of a substrate, a first electrode, a hole injection layer, an electron injection layer, a first charge generation layer, a first emission layer, a second electrode or a passivation layer.

The layer stack may further comprise at least one of a second charge generation layer, a second emission layer and a third emission layer.

In an embodiment, the substrate may be a glass or plastic substrate, for example described in US2005247946.

In another embodiment, the substrate may be a silicon thin-film transistor (TFT) backplane, a poly-silicon backplane, an organic thin-film transistor backplane, CMOS backplane or IGZO backplane.

In another embodiment, the first electrode may be a cathode, an anode, a source electrode, a drain electrode or a gate electrode, preferably an anode.

Preferably, the first electrode is in direct contact with the substrate.

In another embodiment, the light absorption layer is in direct contact with the substrate and the first electrode.

In terms of the present specification, the term "direct contact" means touch contact.

In an embodiment, the first electrode is an anode. The compound used to form the anode electrode may be a high work-function compound, so as to facilitate hole injection. The anode material may also be selected from a low work function material (i.e. Aluminum). The anode electrode may be a transparent or reflective electrode. Transparent conductive compounds, such as indium tin oxide (ITO), indium zinc oxide (IZO), tin-dioxide (SnO2), and zinc oxide (ZnO), may be used to form the anode electrode. The anode electrode may also be formed using magnesium (Mg), aluminum (Al), aluminum-lithium (Al-Li), calcium (Ca), magnesium-indium (Mg-In), magnesium-silver (Mg-Ag), silver (Ag), gold (Au), or the like.

In another embodiment, the first electrode is a cathode. The cathode electrode comprises at least one substantially metallic cathode layer comprising a first zero-valent metal selected from the group consisting of alkali metal, alkaline earth metal, rare earth metal, group 3 transition metal and mixtures thereof.

The term "substantially metallic" shall be understood as encompassing a metal which is at least partially in a substantially elemental form. The term substantially elemental is to be understood as a form that is, in terms of electronic states and energies and in terms of chemical bonds of comprised metals atoms closer to the form of an elemental metal, or a free metal atom or to the form of a cluster of metal atoms, then to the form of a metal salt, of an organometallic metal compound or another compound comprising a covalent bond between metal and non-metal, or to the form of a coordination compound of a metal. It is to be understood that metal alloys represent beside neat elemental metals, atomized metals, metal molecules and metal clusters, any other example of substantially elemental form of metals.

According to another aspect, the substantially metallic cathode layer is free of a metal halide and/or free of a metal organic complex.

In an embodiment, the first electrode is transparent. The first electrode may be arranged on top of the substrate or may be incorporated into the substrate.

In an embodiment, the layers of the layer stack are deposited one after another by vacuum deposition, spin coating, printing, casting, slot-die coating, Langmuir-Blodgett (LB) deposition, or the like. When the individual layers of the layer stack are formed by vacuum deposition, the deposition conditions may vary according to the compound used to form the individual layers, and their desired structure and thermal properties. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

In the present specification, the terms "vacuum deposition" and "vacuum thermal evaporation" have the same meaning.

With respect to all of the layers which may be further comprised in the inventive layer stack, it should be provided that these layers are more transparent (i.e. have a lower absorption) than the light absorption layer.

In a further embodiment, the layer stack comprises (in this order) a substrate, a first electrode, a light absorption layer, an organic semiconductor layer of the present invention, an optional hole transport layer, an optional electron blocking layer, an emission layer, an optional hole blocking layer, an optional electron transport layer, an optional electron injection layer and a second electrode. Preferably, the first electrode is an anode and the second electrode a cathode.

In a further embodiment, the layer stack comprises (in this order) a substrate, a first electrode, a light absorption layer, an organic semiconductor layer of the present invention, an optional first hole transport layer, an optional first electron blocking layer, a first emission layer, an optional first hole blocking layer, an optional first electron transport layer, a charge injection layer, an optional second hole transport layer, an optional second electron blocking layer, a second emission layer, an optional second hole blocking layer, an optional second electron transport layer, an optional electron injection layer and a second electrode. Preferably, the first electrode is an anode and the second electrode a cathode.

In a further embodiment, the layer stack comprises (in this order) a substrate, a first electrode, a light absorption layer, an optional hole injection layer, an optional first hole transport layer, an optional first electron blocking layer, a first

emission layer, an optional first hole blocking layer, an optional first electron transport layer, a charge injection layer comprising an organic semiconductor layer of the present invention, an optional second hole transport layer, an optional second electron blocking layer, a second emission layer, an optional second hole blocking layer, an optional second electron transport layer, an optional electron injection layer and a second electrode. Preferably, the first electrode is an anode and the second electrode a cathode.

In a further embodiment, the layer stack comprises (in this order) a substrate, a first electrode, a light absorption layer, an organic semiconductor layer of the present invention, an optional first hole transport layer, an optional first electron blocking layer, a first emission layer, an optional first hole blocking layer, an optional first electron transport layer, a charge injection layer comprising the organic semiconductor layer, an optional second hole transport layer, an optional second electron blocking layer, a second emission layer, an optional second hole blocking layer, an optional second electron transport layer, an optional electron injection layer and a second electrode. Preferably, the first electrode is an anode and the second electrode a cathode.

In another embodiment, the charge generation layer may comprise more than one organic semiconductor layer, preferably a first and a second organic semiconductor layer. The first and second organic semiconductor layer may be in direct contact.

An interlayer may be arranged between the first and second organic semiconductor layer. The interlayer may comprise or consist of metal, metal complex, metal salt or organic compound. The interlayer may have a thickness of about 0.5 to about 10 nm.

In another embodiment, the charge injection layer may comprise more than one organic semiconductor layer, preferably a first and a second organic semiconductor layer. The first and second organic semiconductor layer may be in direct contact.

In one embodiment, the layer stack further comprises an anode, and the organic semiconductor layer is a hole injection layer. In this regard, it might be preferred that the organic semiconductor layer is in direct contact with the anode or is located close to the anode.

In another embodiment, the organic semiconductor layer comprises a first layer consisting of a first organic compound and a second layer comprising or consisting of a second organic compound. Preferably, the organic semiconductor layer is in direct contact with the anode or forms a charge injection layer.

In one embodiment the first organic compound is selected from the class of hole injection materials and the second organic compound from the class of hole transport materials. In another embodiment the first organic compound is selected from the class of electron injection materials and the second organic compound from the class of electron transport materials.

In the present specification, the term "close to" means a distance of 0 to 50 nm between the surface of the electrode facing the organic semiconductor layer and the surface of organic semiconductor layer facing the electrode. The distance is measured in the direction of the light source.

In a further embodiment, the layer stack further comprises a cathode and the organic semiconductor layer is an electron injection layer. In this regard, it might be provided that the organic semiconductor layer is in direct contact with the cathode or is located close to the cathode.

In another embodiment, the layer stack further comprises a first emission layer and a second emission layer and optional third emission layer, and the organic semiconductor layer may be arranged between a first emission layer and a second emission layer and/or the second and the third emission layer. In this regard, the organic semiconductor layer may be a charge generation layer. Furthermore, the emission layers and the charge generation layer may be in direct contact with each other.

In one embodiment, the first electrode is an anode. The anode may be a transparent anode or a metal anode.

In another embodiment, the first electrode may be a cathode. The cathode may be transparent or may comprise a metal. In a further embodiment, the total thickness of the layer stack may be more than 10 nm and less than 5000 nm. The total thickness of the layer stack may be more than 30 nm and less than 300 nm. The thickness of the light absorption layer may be larger than the thickness of the at least one organic semiconductor layer. The thickness of the light absorption layer may be more than 500 nm and less than 10,000 nm.

The thickness of individual layers on a substrate may be measured by a profilometer Stylus Profiler Dektak XT as provided by Bruker, Billerica, Massachusetts, USA.The thickness of individual layers may be measured on a cross-section of the layer stack by using electron microscopy. Scanning or transmission electron microscopy may be used. A cross-section of the layer stack may be obtained by sample preparation commonly used for microelectronic devices such as focussed-ion beam (FIB) or ultramicrotome preparation, as in US2013110421.

During vacuum deposition of the layers, the layer thickness may be monitored during the deposition process using quartz crystal microbalance (QCM) sensors.

In a further embodiment, the layer stack further comprises a second electrode arranged on the top of the layer stack.

In an embodiment the second electrode structure is transparent. In a further embodiment, it may be provided

that the organic electronic device further comprises an encapsulation.

In a further embodiment, the layer stack further comprises a barrier layer arranged on top of the second electrode. The barrier layer may be transparent. By using a transparent barrier layer and a transparent second electrode irradiation treatment according to the inventive method can be performed after finishing the organic electronic device.

In an embodiment the barrier layer may constitute the encapsulation.

Besides the organic semiconductor layer, the layer stack may comprise further layers known in the art to be suitable to form an organic electronic device. The sequence, the type and the number of the individual layers in the layer stack are not particularly defined or limited.

In another embodiment, irradiation treatment is performed

i) immediately after depositing the organic semiconductor layer onto the light absorption layer;

ii) after depositing one or more further layers and before depositing a second electrode, wherein the second electrode is transparent or non-transparent, preferably non-transparent;

iii) after depositing a second electrode, wherein the second electrode is transparent; and/or

iv) after encapsulation, wherein the encapsulation is transparent.

In another embodiment, the irradiation treatment is performed immediately after depositing the organic semiconductor layer.

In the context of the present specification, the term "transparent" means less than 20% absorption of light, preferably less than 10% absorption of light.

In another embodiment, the layer stack may slide or move above or below the light source during irradiation. This method may be useful for large area substrates and/or roll-to-roll process.

In a further embodiment, the organic semiconductor layer is an essentially non-emissive layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

In another embodiment, a method is provided
for preparing an organic electronic device comprising the steps:

a) providing a layer stack (10) applicable for preparing the organic electronic device, the layer stack comprising:

aa) a light absorption layer (32); and

bb) an organic semiconductor layer having a conductivity of at least $10^{-7}$ S/cm and a thickness of 0.1 to 100 nm;

wherein the distance between the organic semiconductor layer and the light absorption layer (32) is selected from 0 to 500 nm ;

b) providing a light source (11);

c) reducing the conductivity of the organic semiconductor layer by an irradiation treatment of the light absorption layer (32) by exposing it to light from the light source (11);

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack (10) of at least 1 $cm^2$; and

the duration of the irradiation treatment is 10 ms or less and the energy density of the irradiation treatment is from 0.1 to 20 $J/cm^2$ at the position of the light absorption layer (32);

wherein the light absorption layer comprises or consists of an organic compound.

In an embodiment, the light absorption layer comprises or consists of an organic polymer and/or polymer composite.

In a further embodiment, the light absorption layer material may comprise a photoresist (photoresist compound). The photoresist may be a positive or a negative photoresist. A negative resist is a type of photoresist in which the portion of the photoresist that is exposed to light becomes insoluble to the photoresist developer. The unexposed portion of the photoresist is dissolved by the photoresist developer. A positive resist is a type of photoresist in which the portion of the photoresist that is exposed to light becomes soluble to the photoresist developer. The portion of the photoresist that is unexposed remains insoluble to the photoresist developer.

In an embodiment, the negative photoresist comprises a poly-imide compound, for example provided by Asahi Glass Co., Ltd. Or Merck KGaA, Darmstadt, Germany or SU-8 as provided by MicroChem Corp., Westborough, USA.

In an embodiment, the positive photoresist comprises a phenolic resin and a diazonaphthoquinone sensitizer or a polymethyl methacrylate (PMMA) compound, for example provided by Microchemicals GmbH, Ulm, Germany or Brewer Science, INC., Rolla, USA or JSR Micro, Inc., Sunnyvale, USA.

In a further embodiment, the light absorption layer comprises an inorganic compound, wherein the inorganic compound may be an inorganic dielectric compound.

In another embodiment, the light absorption layer comprises or consists of a composite material comprising organic and inorganic compounds or metals.

In another embodiment, the light absorption layer comprises or consists of a composite material comprising an organic compound and at least one metal.

In another embodiment, the thickness of the light absorption layer is at least 100 nm, alternatively 500 nm to 10,000 nm.

In a further embodiment, a method is provided for preparing an organic electronic device comprising the steps:

a) providing a layer stack (10) applicable for preparing the organic electronic device, the layer stack comprising:

aa) a light absorption layer (32); and

bb) an organic semiconductor layer having a conductivity of at least $10^{-7}$ S/cm and a thickness of 0.1 to 100 nm;

wherein the distance between the organic semiconductor layer and the light absorption layer (32) is selected from 0 to 500 nm ;

b) providing a light source (11);

c) reducing the conductivity of the organic semiconductor layer by an irradiation treatment of the light absorption layer (32) by exposing it to light from the light source (11);

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack (10) of at least 1 $cm^2$; and

the duration of the irradiation treatment is 10 ms or less and the energy density of the irradiation treatment is from 0.1 to 20 $J/cm^2$ at the position of the light absorption layer (32);

wherein the light absorption layer is structured.

In the present specification, the term "structured" (or pattern) means a layer having sections which form a layer and sections which are free of the layer. These sections are arranged in the same plane, for example the plane formed by the substrate. The layer may be structured to form a grid.

To reduce cross-talk between pixels, for example in displays, it may be desirable to structure the light absorption layer. Thereby, the conductivity of the organic semiconductor layer may be reduced only in areas which are arranged

between the light source and the light absorption layer, while high conductivity is retained in areas which are not arranged between the light source and the light absorption layer.

In another embodiment, the light absorption layer and the first electrode are structured layers and the organic semiconductor layer is a non-structured layer.

In another embodiment, the light absorption layer and the first electrode are structured layers and the organic semiconductor layer and the other layers comprised in the layer stack are non-structured layers.

In another embodiment, the light absorption layer and the first and second electrode are structured layers and the organic semiconductor layer and the other layers comprising organic compounds comprised in the layer stack are non-structured layers.

In a further embodiment, the light absorption layer may be structured to form a grid on the first electrode, wherein the first electrode is arranged on a substrate, wherein the light absorption layer is present in areas which are not covered by the first electrode and less than 20% of the area of the first electrode is covered by the light absorption layer, preferably less than 10% of the area of the first electrode is covered by the light absorption layer.

In a further embodiment, a method is provided for preparing an organic electronic device comprising the steps:

a) providing a layer stack (10) applicable for preparing the organic electronic device, the layer stack comprising:

aa) a light absorption layer (32); and

bb) an organic semiconductor layer having a conductivity of at least $10^{-7}$ S/cm and a thickness of 0.1 to 100 nm;

wherein the distance between the organic semiconductor layer and the light absorption layer (32) is selected from 0 to 500 nm ;

b) providing a light source (11);

c) reducing the conductivity of the organic semiconductor layer by an irradiation treatment of the light absorption layer (32) by exposing it to light from the light source (11);

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack (10) of at least 1 $cm^2$; and

the duration of the irradiation treatment is 10 ms or less and the energy density of the irradiation treatment is from 0.1 to 20 $J/cm^2$ at the position of the light absorption layer (32);

wherein the light absorption layer comprises or consists of an organic compound and is structured.

If the light absorption layer comprises or consists of an organic compound, it may be structured by a photolithographic process. Photolithography is commonly used in mass production of organic electronic devices to create high resolution structures.

Preferably, the organic compound is selected from a photoresist (photoresist compound).

In another embodiment, the light absorption layer may be a pixel definition layer, as described in US2005247946.

In a further embodiment, the first electrode may be structured to form a pixel electrode, for example described in US2005247946.

In a further embodiment, the first electrode structure constitutes a variety of pixels on the substrate having a pixel gap of less than 50 μm, alternatively from 1 μm to 30 μm, and a pixel pitch less than 150 μm, alternatively from 2 μm to 125 μm.

In another embodiment, a method is provided for preparing an organic electronic device comprising a variety of organic light emitting diodes. Each of the organic light emitting diodes comprised in the organic electronic device may in this case be formed above one part of the first electrode structure.

In another embodiment, one or more pixels are formed by the first electrode structure in a way that the open areas of the grid are arranged above the electrode structure and, afterwards, the layer stack is arranged thereon.

In a further embodiment, the irradiation treatment is performed by exposing the light absorption layer to light from the light source through a photomask.

In this regard, it may be provided that the photomask is a structured photomask (the term "structured" defined as above) and the structure of the photomask corresponds to the structure of the first electrode and/or corresponds to areas not covered by the light absorption layer. It may further be provided that the photomask is transparent in the areas, where the light absorption layer is present and opaque in areas where the light absorption layer is not present.

The organic semiconductor layer in terms of the disclosure has a conductivity of at least $10^{-7}$ S/cm, preferably at least 10-5 S/cm. The conductivity may be measured by a parameter analyzer Keithley 4200A-SCS as provided by Tektronix, Beaverton, USA according for example to the four terminal sensing method, as described for example in DK Schroder, Semiconductor material and device characterization, Wiley, 1990.

In another embodiment, a method is provided
for preparing an organic electronic device comprising the steps:

a) providing a layer stack (10) applicable for preparing the organic electronic device, the layer stack comprising:

aa) a light absorption layer (32); and

bb) an organic semiconductor layer having a conductivity of at least $10^{-7}$ S/cm and a thickness of 0.1 to 100 nm;

wherein the distance between the organic semiconductor layer and the light absorption layer (32) is selected from 0 to 500 nm ;

b) providing a light source (11);

c) reducing the conductivity of the organic semiconductor layer by an irradiation treatment of the light absorption layer (32) by exposing it to light from the light source (11);

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack (10) of at least 1 $cm^2$; and

the duration of the irradiation treatment is 10 ms or less and the energy density of the irradiation treatment is from 0.1 to 20 $J/cm^2$ at the position of the light absorption layer (32);

wherein the organic semiconductor layer comprises a redox dopant.

Surprisingly, it was found that the present invention may be particularly suited to reduce cross-talk in organic electronic devices comprising an organic semiconductor layer comprising a redox dopant.

In the context of the present disclosure, the term "redox dopant" refers to a dopant which increases electrical conductivity of the organic semiconductor layer. The redox dopant is essentially non-emissive. The term "essentially non-emissive" means that the contribution of the redox dopant to the emission spectrum from the device is less than 10 %, it may be less than 5 % relative to the emission spectrum or may be entirely absent.

According to another embodiment, the organic semiconductor layer may consist of a redox dopant.

In another embodiment, the organic semiconductor layer may comprise a redox dopant and an organic matrix compound.

In a further embodiment the organic semiconductor layer comprises a first layer comprising of a redox dopant and a second layer comprising an organic matrix compound, which may further comprise a redox dopant.

In a further embodiment, (i) the organic semiconductor layer consists of a redox dopant, or (ii) the organic semiconductor layer comprises a redox dopant and a matrix material, the matrix material being a charge transport material, or (iii) the organic semiconductor layer comprises a first layer comprising an redox dopant and a second layer comprising a charge transport compound and an optional redox dopant.

The redox dopant may be a p-type or an n-type dopant.

In another embodiment, the organic semiconductor layer comprises or consists of a redox dopant, wherein the redox dopant is selected from:

1. a p-type dopant selected from

1.1. an organic or organometallic molecular dopant having a molecular weight of about 350 to about 1700 which may be selected from dimalonitrile compound, a quinone compound, an aromatic/heteroaromatic nitrile compound, a fullerene compound or a radialene compound, preferably a radialene compound of formula 1, wherein $Ar_{1-3}$ are the same or different and independently selected from aryl or heteroaryl;

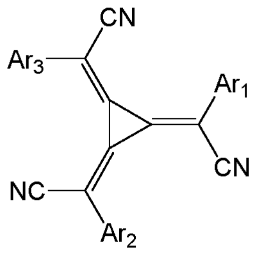

Formula 1;

or

1.2. a transition metal oxide, which may be selected from $MoO_3$ and $V_2O_5$; or

1.3. a Lewis acid compound, which may be a (trifluoromethanesulfonyl)imide compound and may be selected from the bis(trifluoromethansulfanoyl)imides of a metal of groups 1 to 12 of the periodic system of elements, preferably the metal of Groups 1 to 12 may be selected from Na, K, Li, Mg, Ba, Sc, Mn, Cu, Ag or mixtures thereof Or;

2. an n-type dopant selected from

2.1. an organic or organometallic molecular dopant having a molecular weight of about 300 to about 1500, or
2.2. a metal dopant selected from the group consisting of a metal halide having a molecular weight of about 25 to about 500, a metal complex having a molecular weight of about 150 to about 1500, and a zero-valent metal selected from the group consisting of alkali metal, alkaline earth metal, and rare earth metals.

The term "molecular weight" or "molecular mass" is a physical property defined as the mass of a given molecule. The base SI unit for molecular weight is kg/mol. For historical reasons, molecular weights are almost always expressed in g/mol. So are they in this disclosure. The molecular weight may be calculated from standard atomic masses. It is the sum of all standard atomic masses in a compound. The standard elemental atomic masses are given in the periodic table of elements.
In another embodiment, a method is provided for preparing an organic electronic device comprising the steps:

a) providing a layer stack applicable for preparing the organic electronic device, the layer stack comprising:

aa) a light absorption layer; and

bb) an organic semiconductor layer having a conductivity of at least $10^{-7}$ S/cm and a thickness of 0.1 to 100 nm;

wherein the distance between the organic semiconductor layer and the light absorption layer is selected from 0 to 500 nm ;

b) providing a light source;

c) irradiation treatment of the light absorption layer by exposing it to light from the light source;

wherein the irradiation treatment is uniform with respect to a surface area of the layer stack of at least 1 $cm^2$, preferably at least 100 $cm^2$;

the duration of the irradiation treatment is 10 ms or less and the energy density of the irradiation treatment is from 0.1 to 20 $J/cm^2$ at the position of the light absorption layer; and

the absorption of the light absorption layer with respect to the light irradiated from the light source is higher than the respective absorption of the organic semiconductor layer;

wherein the organic semiconductor layer comprises a radialene compound, preferably a radialene compound of formula 2:

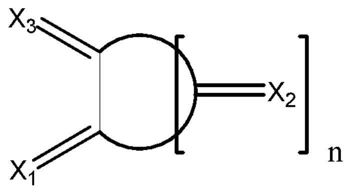

Formula 2

in which n = 1-4; each $X_1$, $X_2$, $X_3$, $X_4$ and $X_5$ is independently selected from the group consisting of $C(CN)_2$, $(CF_3)C(CN)$, $(NO_2)C(CN)$, C(halogen)$_2$, $C(CF_3)_2$, NCN, O, S, $NR_1$,

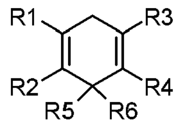
A

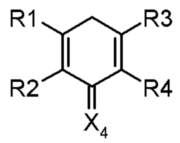
B

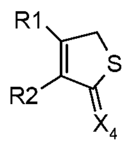
C

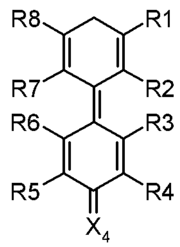
D

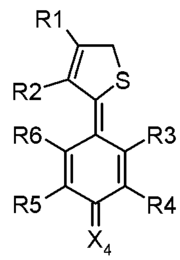
E

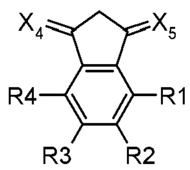
F

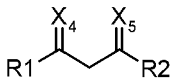
G

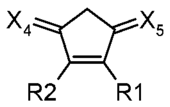
H

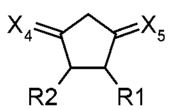
I

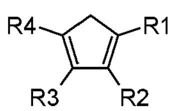
J

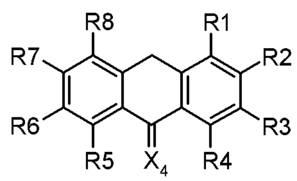
K

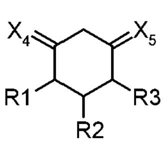
L

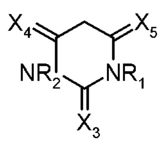
M

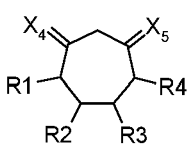
N

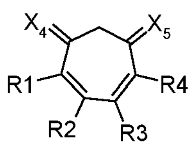
O

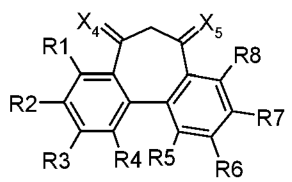
P

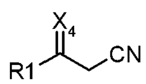
Q

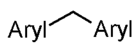
R

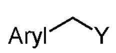
S

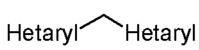
T

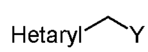
U

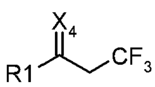
V

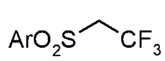
W

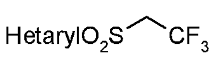
W1

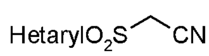
W2

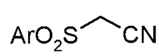
W3

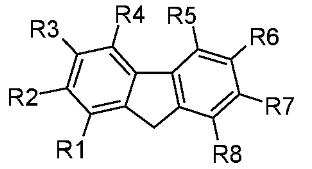

W4

in which Y = CN, $NO_2$, $COR_1$ or is perhalogenated $C_1$ to $C_{16}$ alkyl; $C_6$ to $C_{24}$ aryl or Ar is a substituted or unsubstituted aromatic $C_6$ to $C_{24}$ hydrocarbon or $C_{12}$ to $C_{24}$ biaryl, optionally polycyclic; hetaryl is a substituted or unsubstituted aromatic $C_3$ to $C_{24}$ heterocyclic compound or $C_6$ to $C_{24}$ biheteroaryl, preferably electron-poor, optionally polynuclear or partially or completely hydrogenated or fluorinated; and Ri-Rs are independently selected from hydrogen, halogen, CN, $NO_2$, $COR_1$, $C_1$ to $C_{16}$ alkyl, $C_1$ to $C_{16}$ alkoxy, $C_6$ to $C_{24}$ aryl and $C_3$ to $C_{24}$ heteroaryl.

According to another embodiment, in compound of formula 2,

- Y is CN or perfluoroalkyl, such as $CF_3$; and/or
- Aryl is partially or completely fluorinated; and/or
- Hetaryl is selected from pyridyl, pyrimidyl, triazine and oxadiazole; and/or
- Ri-Rs are independently selected from perhalogenated and/or partially halogenated alkyl groups, especially perfluorinated alkyl groups; and/or
- n is 1.

Preferably, Y is CN, Aryl is selected from partially or fully fluorinated phenyl and n is 1.
In another embodiment, a method is provided
for preparing an organic electronic device comprising the steps:

a) providing a layer stack (10) applicable for preparing the organic electronic device, the layer stack comprising:

aa) a light absorption layer (32); and

bb) an organic semiconductor layer having a conductivity of at least $10^{-7}$ S/cm and a thickness of 0.1 to 100 nm;

wherein the distance between the organic semiconductor layer and the light absorption layer (32) is selected from 0 to 500 nm ;

b) providing a light source (11);

c) reducing the conductivity of the organic semiconductor layer by an irradiation treatment of the light absorption layer (32) by exposing it to light from the light source (11);

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack (10) of at least 1 $cm^2$; and

the duration of the irradiation treatment is 10 ms or less and the energy density of the irradiation treatment is from 0.1 to 20 $J/cm^2$ at the position of the light absorption layer (32);

wherein the organic semiconductor layer comprises a radialene compound, preferably the radialene compound is a compound of formula 2a

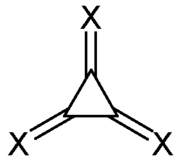

Formula 2a

in which each X is

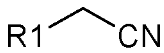

wherein each Ri being independently selected from $C_6$ to $C_{24}$ aryl and $C_3$ to $C_{24}$ heteroaryl, $C_6$ to $C_{24}$ aryl and $C_3$ to $C_{24}$ heteroaryl being at least partially, preferably completely, substituted with electron acceptor groups.

In another embodiment, in compound of formula 2a, the electron acceptor groups are selected from cyano, fluoro, trifluoromethyl, chloro and bromo.

In another embodiment, in compound of formula 2a, Ri is selected from perfluoropyridin-4-yl, tetrafluoro-4-(trifluoromethyl)phenyl), 4-cyanoperfluorophenyl, dichloro-3,5-difluoro-4-(trifluoromethyl)phenyl, and perfluorophenyl

In another embodiment, a method is provided for preparing an organic electronic device comprising the steps:

a) providing a layer stack (10) applicable for preparing the organic electronic device, the layer stack comprising:

aa) a light absorption layer (32); and

bb) an organic semiconductor layer having a conductivity of at least $10^{-7}$ S/cm and a thickness of 0.1 to 100 nm;

wherein the distance between the organic semiconductor layer and the light absorption layer (32) is selected from 0 to 500 nm ;

b) providing a light source (11);

c) reducing the conductivity of the organic semiconductor layer by an irradiation treatment of the light absorption layer (32) by exposing it to light from the light source (11);

wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;

wherein the irradiation treatment is uniform with respect to a surface area of the layer stack (10) of at least 1 $cm^2$; and

the duration of the irradiation treatment is 10 ms or less and the energy density of the irradiation treatment is from 0.1 to 20 $J/cm^2$ at the position of the light absorption layer (32);

- wherein the organic semiconductor layer comprises or consists of a metal salt or metal complex, wherein the metal is selected from group 1, 2, 3 or from transition metals.

In another embodiment, the organic semiconductor layer comprises or consists of a metal salt or metal complex, wherein the metal is selected from group 1, 2, 3 or from transition metals and the organic semiconductor layer is arranged between the anode and the emission layer and/or between a first and second emission layer and/or between a second and third emission layer.

In another embodiment, a method is provided for preparing an organic electronic device comprising the steps:

- a) providing a layer stack applicable for preparing the organic electronic device, the layer stack comprising:

- aa) a light absorption layer; and
- bb)an organic semiconductor layer having a conductivity of at least $10^{-7}$ S/cm and a thickness of 0.1 to 100 nm;
- wherein the distance between the organic semiconductor layer and the light absorption layer is selected from 0 to 500 nm ;
- b) providing a light source;
- c) irradiation treatment of the light absorption layer by exposing it to light from the light source;
- wherein the irradiation treatment is uniform with respect to a surface area of the layer stack of at least 1 $cm^2$, preferably at least 100 $cm^2$;
- the duration of the irradiation treatment is 10 ms or less and the energy density of the irradiation treatment is from 0.1 to 20 $J/cm^2$ at the position of the light absorption layer; and
- the absorption of the light absorption layer with respect to the light irradiated from the light source is higher than the respective absorption of the organic semiconductor layer;
- wherein the organic semiconductor layer comprises a redox dopant and further comprises an organic matrix compound, preferably a triarylamine compound.

Suitable triarylamine compounds are disclosed for example in Y. Shirota and H. Kageyama, Chem. Rev. 2007, 107, 953 - 1010.

In another embodiment, the organic semiconductor layer comprises or consists of an organic compound, preferably compound comprising at least one malonitrile group or a dipyrazino[2,3-f:2',3'-h]quinoxaline compound, preferably a compound of formula 3:

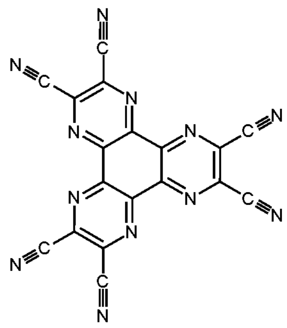

Formula 3.

In another embodiment, the organic semiconductor layer comprises of a first layer consisting of a first organic compound, preferably compound comprising at least one malonitrile group or a dipyrazino[2,3-f:2',3'-h]quinoxaline compound, preferably a compound of formula 3:

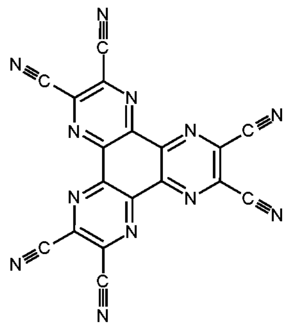

Formula 3;

and

a second layer comprising or consisting of a second organic compound. Preferably, the second organic compound is selected from a triarylamine compound. Also preferred, the first organic compound is selected from compound of formula 3 and the second organic compound is selected from a triarylamine compound.

The organic semiconductor layer is free of an emitter dopant.

The term "free of", "does not contain", "does not comprise" does not exclude impurities which may be present in the compounds prior to deposition. Impurities have no technical effect with respect to the object achieved by the present invention.

In an embodiment the layer stack may comprise one or several layers selected from the group of:
Hole-injection layer (HIL). Examples of compounds that may be used to form the HIL include a phthalocyanine compound, such as copper phthalocyanine (CuPc), 4,4',4"-tris (3-methylphenylphenylamino) tri-phenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS). The HIL may be a layer consisting of a p-type dopant or may be selected from a hole-transporting matrix compound redox-doped doped with a p-type dopant. Typical examples of known redox-doped hole transport materials are: copper phthalocyanine (CuPc) doped with tetrafluoro-tetracyanoquinonedimethane (F4TCNQ), zinc phthalocyanine (ZnPc) doped with F4TCNQ, α-NPD (N,N'-Bis(naphthalen-1-yl)-N,N'-bis(phenyl)-benzidine) doped with F4TCNQ, α-NPD doped with 2,2'-(perfluoronaphthalen-2,6-diylidene) dimalononitrile, α-NPD doped with 2,2',2"-(cyclopropane-1,2,3-triylidene)tris(2-(p-cyanotetrafluorophenyl)acetonitrile). Dopant concentrations may be selected from 1 to 20 wt.-%, alternatively from 3 wt.-% to 10 wt.-%.

Hole-transport layer (HTL). The HTL may be formed of any compound that is commonly used to form an HTL. Compound that can be suitably used is disclosed for example in Yasuhiko Shirota and Hiroshi Kageyama, Chem. Rev. 2007, 107, 953-1010 and incorporated by reference. Examples of the compound that may be used to form the HTL are: a carbazole derivative, such as N-phenylcarbazole or polyvinylcarbazole; an amine derivative having an aromatic condensation ring, such as N,N'-bis(3-methylphenyl)-N,N'-diphenyl-[1,1-biphenyl]-4,4'-diamine (TPD), or N,N'-di(naphthalen-1-yl)-N,N'-diphenyl benzydine (alpha -NPD); and a triphenylamine-based compound, such as 4,4',4"-tris(N-carbazolyl)triphenylamine (TCTA).

Electron blocking layer (EBL). Typically, the EBL comprises a triarylamine or a carbazole compound. If the electron blocking layer has a high triplet level, it may also be described as triplet control layer. The function of the triplet control layer is to reduce quenching of triplets if a phosphorescent green or blue emission layer is used. Thereby, higher efficiency of light emission from a phosphorescent emission layer can be achieved in an OLED device. The triplet control layer is selected from triarylamine compounds with a triplet level above the triplet level of the phosphorescent emitter in the adjacent emission layer. Suitable triplet control layer, in particular the triarylamine compounds, are described in EP 2 722 908 A1.

Emission layer (EML). The EML is commonly used in OLED and may be a combination of a host and an emitter dopant. The emitter dopant largely controls the emission spectrum of an EML. Examples of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-Tris(carbazol-9-yl)-triphenylamine (TCTA), 1,3,5-tris(N-phenylbenzimidazole-2-yl)benzene (TPBI), 3-tert-butyl-9,10-di-2-naphthylanthracenee (TBADN), distyrylarylene (DSA), Bis(2-(2-hydroxyphenyl)benzothiazolate), zinc (Zn(BTZ) 2). The emitter dopant may be a phosphorescent or fluorescent emitter. Phosphorescent emitters and emitters which emit light via a thermally activated delayed fluorescence (TADF) mechanism may be used due to their higher efficiency. The emitter dopant may be a small molecule or a polymer. Examples of a red emitter dopant are PtOEP, $Ir(piq)_3$, and $Btp_2Ir(acac)$, but are not limited thereto. These compounds are phosphorescent emitters, however, fluorescent red emitter dopants could also be used.

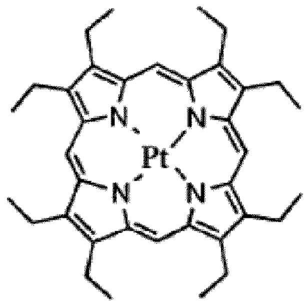

PtOEP

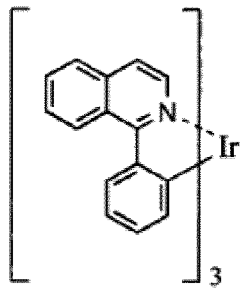

$Ir(piq)_3$

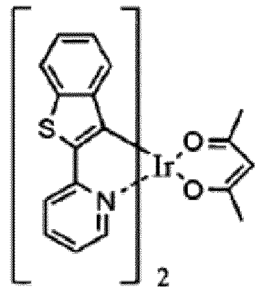

$Btp_2Ir(acac)$

Examples of a phosphorescent green emitter dopant are $Ir(ppy)_3$ (ppy = phenylpyridine), $Ir(ppy)_2(acac)$, $Ir(mpyp)_3$ are shown below.

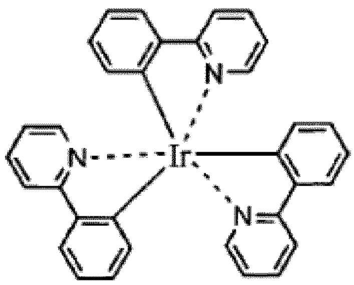

$Ir(ppy)_3$

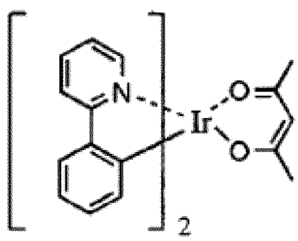

$Ir(ppy)_2(acac)$

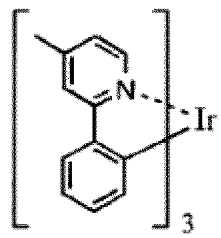

$Ir(mpyp)_3$

Examples of a phosphorescent blue emitter dopant are $F_2Irpic$, $(F_2ppy)_2Ir(tmd)$ and $Ir(dfppz)_3$, terfluorene, the structures are shown below. 4.4'-bis(4-diphenyl amiostyryl)biphenyl (DPAVBi),2,5,8,11-tetra-tert-butyl perylene (TBPe) are examples of fluorescent blue emitter dopants.

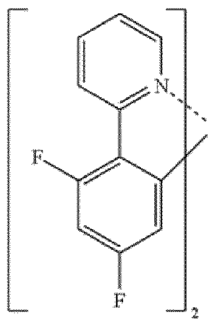

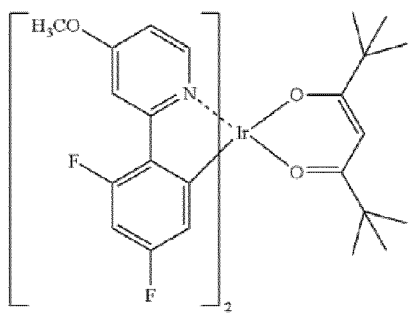

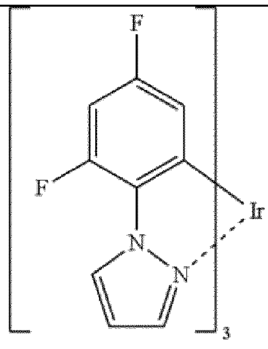

$F_2Irpic$ $(F_2ppy)_2Ir(tmd)$ Ir(dfppz) 3

Hole-blocking layer (HBL). Any compound that is commonly used to form a HBL may be used. Examples of compounds for forming the HBL include an oxadiazole derivative, a triazole derivative, and a phenanthroline derivative.

Electron transport layer (ETL). The ETL may comprise matrix compounds and additives or n-type dopants. The matrix compounds may be selected from the group of benzo[k]fluoranthene, pyrene, anthracene, fluorene, spiro(bifluorene), phenanthrene, perylene, triptycene, spiro[fluorene-9,9'-xanthene], coronene, triphenylene, xanthene, benzofurane, dibenzofurane, dinaphthofurane, acridine, benzo[c]acridine, dibenzo[c,h]acridine, dibenzo[a,j]acridine, triazine, pyridine, pyrimidine, carbazole, phenyltriazole, benzimidazole, phenanthroline, oxadiazole, benzooxazole, oxazole, quinazoline, ben-zo[h]quinazoline, pyrido[3,2-h]quinazoline, pyrimido[4,5-f]quinazoline, quinoline, benzo-quinoline, pyrrolo[2,1-a]isoquinolin, benzofuro[2,3-d]pyridazine, thienopyrimidine, dithienothiophene, benzothienopyrimidine, benzothienopyrimidine, phosphine oxide, phosphole, triaryl borane, 2-(benzo[d]oxazol-2-yl)phenoxy metal complex, 2-(benzo[d]thiazol-2-yl)phenoxy metal complex or mixtures thereof. The additives or n-type dopants may be selected from the group of metal, metal complex, metal halide, guanidine or phosphine-imine, acridine orange base (AOB); tetrakis ( 1,3,4,6,7,8 - hexahydro - 2H - pyrimido [ 1,2 - a] pyrimidinato) ditungsten (II) ($W_2(hpp)_4$); 3,6-bis-(dimethyl amino)-acridine; bis(ethylene-dithio) tetrathiafulvalene (BEDT-TTF); oxocarbon; pseudooxocarbonderivatives.

Electron injection layer (EIL). The EIL may comprise alkali, alkaline earth or rare earth metals or complexes or salts of alkali, alkaline earth or rare earth metals. The EIL may comprise an organic matrix compound selected from the group of phosphine oxides, diphenylphosphine oxides, benzimidazoles, phenanthrolines, quinazolines, benzo[h]quinazolines, pyrido[3,2-h]quinazolines. The EIL may comprise additives or n-type dopants. The additives or n-type dopants may be selected from the group of metal, metal complex, metal halide, guanidine or phosphine-imine, acridine orange base (AOB); tetrakis ( 1,3,4,6,7,8 - hexahydro - 2H - pyrimido [ 1,2 - a] pyrimidinato) ditungsten (II) ($W_2(hpp)_4$); 3,6-bis-(dimethyl amino)-acridine; bis(ethylene-dithio) tetrathiafulvalene (BEDT-TTF); oxocarbon; pseudooxocarbonderivatives.

Charge generation layer (CGL). The CGL is described in US 2012098012 for use in OLED but may be used in other electronic devices. The CGL is generally composed of a double layer wherein the two layers of the double layer CGL may be separated by an interlayer having a thickness of about 0.5 to about 10 nm. The material of the interlayer may be a metal, a metal complex, a metal salt or an organic compound.

The CGL may also be described as pn junction. The CGL may comprise a p-type CGL and n-type CGL. The p-type CGL may comprise metal or organic host material doped with p-type dopant. Here, the metal can be one or an alloy consisting of two or more selected from a group consisting of Al, Cu, Fe, Pb, Zn, Au, Pt, W, In, Mo, Ni, and Ti. Also, p-type dopant and host material can employ conventional materials. For example, the p-type dopant can be one selected from a group consisting of tetrafluore-7,7,8,8-tetracyanoquinodimethane (F4-TCNQ), derivative of tetracyanoquinodimethane, radialene derivative, iodine, $FeCl_3$, $FeF_3$, and $SbC1_5$. The host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB). The n-type charge generation layer can be composed of metal or organic material doped with n-type dopant. The metal can be one selected from a group consisting of Li, Na, K, Rb, Cs, Mg, Ca, Sr, Ba, La, Ce, Sm, Eu, Tb, Dy, and Yb. Also, n-type dopant and host material can employ conventional

materials. For example, the n-type dopant can be alkali metal, alkali metal compound, alkali earth metal, or alkali earth metal compound. More specifically, the n-type dopant may be selected from a group consisting of Cs, K, Rb, Mg, Na, Ca, Sr, Eu and Yb. The n-type dopants may also be selected from the group of metal complex, metal halide, guanidine or phosphine-imine, acridine orange base (AOB); tetrakis ( 1,3,4,6,7,8 - hexahydro - 2H - pyrimido [ 1,2 - a] pyrimidinato) ditungsten (II) ($W_2(hpp)_4$); 3,6-bis-(dimethyl amino)-acridine; bis(ethylene-dithio) tetrathiafulvalene (BEDT-TTF); oxocarbon; pseudooxocarbonderivatives. The host material can be one selected from a group consisting of tris(8-hydroxyquinoline)aluminum, triazine, hydroxyquinoline derivative, benzazole derivative, and silole derivative.

A photoelectric conversion layer. The photoelectric conversion layer may be a single layer or a flat hetero-junction double layer or a bulk-hetrojunction layer as used in solar cell devices. The photoelectric conversion layer comprises at least one absorber compound. The flat hetero-junction double layer and the bulk-hetrojunction layer may comprise an electron acceptor material like fullerene C60 and an electron-donor material like P3HT. The photoelectric conversion layer may comprise a material crystallizing in the perovskite structure having a stoichiometry of $AMX_3$ or $A_2MX_4$, where "A" and "M" are cations and "X" is an anion. The photoelectric conversion layer may be the photoelectric conversion layer of a photosensor.

A dielectric layer. The dielectric layer may be used in transistor devices and comprises a dielectric material that is a substance that is a poor conductor of electricity, but an efficient supporter of electrostatic field. The dielectric material may be an organic or inorganic. Inorganic dielectric materials may be oxides and nitrides. The inorganic materials may be selected from the group of $SiO_2$, $Ta_2O_5$, $Al_2O_3$, $SiN_x$. The organic dielectric materials may be selected from the group of polyvinylpyrrolidone, polymethylmethacrylate, polyimide, polytetrafluor-ethylene, polyperfluoroalkenylvinylether, polychloro pyrene, polyethylene terephthalate, polyoxymethylene, polyvinylchloride, polyvinylidene fluoride, polyvinylphenol, poly sulfone, polycarbonate, or any type of photoresist used in lithography

A further semiconductor layer. P-type semiconductors for the semiconducting layer may be: pentacene, dinaphthothienothiophene (DNTT), further DNTT derivatives such as C10-DNTT (in general Cx-DNTT), Metal-Phthalocyanines (ZnPc,CuPc), perylenes such as Diindenoperylenes (DIP), Tetrapropyl-tetraphenyl-diindenoperylene (P4-PH4-DIP). N-type semiconductors for the semiconducting layer may be: C60, C70, ZnPc, CuPc, F16CuPc, F4CuPc, Diindenoperylenes (DIP). Also be tri-phenyl-diamine (TPD), 3-(N-Maleimidopropionyl)-biocytin (MPB), Bathophenanthroline (BPHEN), 2,4,7,9-tetraphenyl-1, 10- phenanthroline (TPHEN), perylene-3,4,9,10-tetracarboxylie-3,4,9,10-dianhydride (PTCDA), naphthalene tetracarboxylic acid di-anhydride (NTCDA) may be used. Further, the semiconductor material can be a polymer, for example p-type materials like poly(3-hexylthiophen-2,5-diyl) (P3HT), DIPs-pentacene, poly[2,5-bis(3-alkylthiophen-2-yl)thieno(3,2-b)thiophene] (PBTTT) or n-type materials like poly{[N,N9-bis(2-octyldodecyl)-naphthalene-1,4,5,8-bis(dicarboximide)-2,6-diyl]-alt-5,59-(2,29-bithiophene)} (P(NDI2OD-T2).

Finally, the object is achieved by a device comprising the inventive organic electronic device.

In this regard, it may be provided that the device is a display device.

In a further embodiment, the first electrode structure constitutes pixels of the display device.

The object further achieves organic electronic device obtainable by the inventive method.

In one embodiment, the organic electronic device is an OLED, a photodetector, a transistor or a solar cell, preferably an OLED.

The object is finally achieved by a device comprising the inventive organic electronic device.

In one embodiment the device is a display device.

In a further embodiment, the first electrode structure constitutes pixels of the display device.

All numeric values are herein assumed to be prefixed by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "does not contain" does not include impurities. Impurities have no technical effect with respect to the object achieved by the present disclosure.

Description of the Drawings

Following, the disclosure will be described in detail by referring to specific exemplary materials and conditions for performing the method by referring to the enclosed figures. In the figures show:

| | |
|---|---|
| Fig. 1 | Schematic view of the layer stack placed under the fluid cooled Xenon flash lamp |
| Fig. 2 | Test layout for measurements of the cross-talk current |
| Fig. 3a | Schematic cross-sectional view of the layer stack a) before irradiation, b) with irradiation, c) after irradiation. |
| Fig. 3b | Schematic cross-sectional view of the layer stack during irradiation |
| Fig. 4 | Cross-talk current ratio before and after irradiation |

Fig. 5 Light absorption of light absorption layer vs organic semiconductor layer
Fig. 6 Schematic cross-sectional view of a layer stack with a masked active area

Fig.7 Current vs. voltage and efficiency vs. current density measured on an OLED stack before and after irradiation.

Fig. 1 shows a schematic view of the layer stack 10 being arranged below the light source of the pulsed radiation 11 during irradiation at a distance of 25 mm. The layer stack 10 may be mounted on a sample holder 12. The method according to the disclosure utilizes light pulses based on single visible light flashes t ≤ 2 ms. Thus, only little heat is introduced to the substrate, assuring temperature increase only locally and no heat dissipation and low thermal stress to non-irradiated areas.

Fig. 2 shows a schematic view of the test layout used in examples 1 to 7 and comparative examples 1 to 7 to measure the cross-talk current between the first electrode of a first pixel 21 and the first electrode of a second pixel 22. The pixel gap in the test layout corresponds to the smallest distance between first electrode of a pixel 21 and the first electrode of a second pixel 22. In this test layout the pixel gap is 40 μm (also named channel length, 25) which is very similar to a real pixel gap used for example in AMOLED display production. The length over which the electrodes face each other 26 can be defined as channel length.

Fig. 3a shows a schematic cross-sectional view of the layer stack in example 1 a) before irradiation, b) during irradiation, c) after irradiation. The layer stack comprises a substrate 31, a light absorption layer 32, a layer stack 33 comprising the organic semiconducting layer in a distance from 0 to 500 nm with respect to the light absorption layer 32, a first electrode of a first pixel 34 and a first electrode of a second pixel 35. Before irradiation treatment (Fig. 3a) the organic semiconductor layer in the layer stack has the same conductivity above the area of the first electrode and above the light absorption layer material. The conductivity was calculated as follows:

$$Resistance = \frac{5V}{I_{Channel@5V}}$$

$$b = \frac{Resistance}{Channel\ length}$$

$$\sigma = \frac{1}{b \cdot Channel\ width \cdot Layer\ thickness}$$

Channel width = 9.5 cm
Layer thickness= 10 nm

b = 257259 ohms/μm
= 2.57e9 ohms/cm

= 10e-7 cm
$\sigma_{before\ irradiation}$ = 4-09e-5 S/cm

In Fig. 3b it is shown that the light beam 32 during irradiation is arranged in a 90 degree angle to the main plane of the light absorption layer 38. In Fig. 3b the ↔ symbol 39 symbolizes the direction in which the distance between the light absorption layer 32 and the organic semiconducting layer comprised in the layer stack 33 is measured. In Fig. 3b, the scenario a) on the left side is the "correct" scenario in accordance with the invention for measuring the distance between the light absorption layer 32 and the organic semiconducting layer, i.e. in the direction of the light beam 38. The scenario b) shown on the right side of Fig. 3b is the "wrong" way to measure the distance between the absorption layer 32 and the organic semiconducting layer, namely perpendicular to the direction of the light beam 38.

Example 1

Organic electronic devices are expensive to fabricate, therefore the test lay-out as described in Fig. 2 was used to determine the effect of the irradiation treatment on the conductivity of an organic semiconductor layer and cross-talk between neighboring electrodes. The current between electrodes 21 and 22 (Fig. 2) can be taken a measure for cross-talk current in an organic electronic device comprising the organic semiconductor layer. The lower the current between neighboring electrodes, the more effective is the method of the present invention at reducing cross-talk.

To demonstrate the technical effect of the invention, a 15Ω /cm$^2$ glass substrate with 90 nm ITO (available from Corning Co.) was cut to a size of 50 mm × 50 mm × 0.7 mm, ultrasonically cleaned with isopropyl alcohol for 5 minutes and then with pure water for 5 minutes, and cleaned again with UV ozone for 30 minutes, to prepare a first electrode. Then, it was structured to form a first electrode 21 and second electrode 22 with a gap of 40 μm between electrode 21 and electrode 22, see Fig. 2. On top of the electrodes 21 and 22, a 1.5 μm thick polyimide grid 23 was deposited using

photolithographic process as light absorption layer. The organic semiconductor layer 24 comprised the compounds Biphenyl-4-yl(9,9-diphenyl-9H-fluoren-2-yl)-[4-(9-phenyl-9H-carbazol-3-yl)phenyl]-amine (HTM 1) as charge transport compound and 4,4',4"-((1E,1'E,1"E)-cyclopropane-1,2,3-triylidenetris(cyanomethanylylidene))tris(2,3,5,6-tetrafluorobenzonitrile) (Dopant 1) as redox dopant in a weight ratio of 92:8. The compounds were co-deposited by thermal vacuum deposition to form the organic semiconductor layer. The layer thickness of the organic semiconductor layer was 10nm. The organic semiconductor layer 24 was in direct contact with the first electrode 21 and second electrode 22. This layer may also be described as hole injection layer (HIL), as it may improve hole injection. A robot was used to contact the electrodes 21 and 22. The current between the electrodes 22 and 23 were measured with a parameter analyzer Keithley S4200 as provided by Tektronix, Beaverton, USA. The conductivity of the organic semiconductor layer is about 4 × 10-5 S/cm before irradiation treatment.

Table 1 shows the measured currents at 5 V on test layout for 40 μm channel which corresponds in this case to the pixel pitch, see Fig. 2. The comparative example 1 was not irradiated. The example 1.1 was irradiated with a pulse energy density of 4 $J/m^2$, the example 1.2 was irradiated with a pulse energy density of 4.5 $J/m^2$ and the example 1.3 was irradiated with a pulse energy density of 5 $J/m^2$. Cross-talk current decreases significantly with pulse energy density showing a current reduction by more than a factor of 1000 for example 1.3. Already for example 1.2 the cross-talk current is reduced to < 1 nA.

Table 1. Cross-talk currents on test layout for 40 μm channel at 5 V, organic semiconductor layer thickness 10nm (Example 1), current measured with S4200/robot

| Sample | Irradiation Pulse energy density | Pulse length | current before treatment | current after treatment | Cross-talk current reduction ratio $I_{after}/I_{before}$ |
|---|---|---|---|---|---|
| | [$J/cm^2$] | [ms] | [nA] | [nA] | |
| Comparative example 1 | 0 | 1 | 450.4 | 488.300 | 1/0.92 |
| Example 1.1 | 4 | 1 | 464.3 | 15.201 | 1/30.5 |
| Example 1.2 | 4.5 | 1 | 459.4 | 1.196 | 1/384 |
| Example 1.3 | 5 | 1 | 462.1 | 0.212 | 1/2185 |

Fig. 4 depicts the values in Table 1 above graphically.

In Fig. 4 it can be seen, that after irradiation treatment of the layer that the organic semiconductor layer in the layer stack 33 has an unchanged conductivity above the area of the first electrode (layer stack area 37) whereas in the area above the light absorption layer material (layer stack area 36) the cross-talk current is significantly reduced. After irradiation, cross-talk currents were very small (<100 pA).

Fig. 5 shows the absorption spectra of the photoresist comprised in the light absorption layer in Example 1 (polyimide grid) and of the organic semiconductor material (HIL). In the sense of the present invention, it is important that the absorption of the light absorption layer is higher than the absorption of the compound comprised in the organic semiconductor layer to bring about the desired technical effect. It was experimentally determined that when exposed to a Xenon flash lamp the proportion of light absorbed by the light absorption layer was 38.7%, while the absorption of the organic semiconductor material was only 7.9%. Any high power source with appropriate light spectrum capable of producing defined short pulses in millisecond range (e.g. LED) may also be suitable. The type and wavelength of the irradiation source is not particularly restricted or defined. Important is that the proportion of light absorbed by the light absorption layers is higher than the light absorption of the organic semiconductor layer over a large usable wavelength rage.

As desired, the cross-talk current which can flow through the organic semiconductor layer between the first electrode of a first pixel 34 and the first electrode of a second pixel 35 is also significantly reduced, see Figure 3.

In example 2 to 6 and comparative examples 2 to 6 were fabricated as described for Example 1 above.

Example 2

The organic semiconductor layer 24 was a hole-injection layer (HIL), which comprises the hole transporting material HTM1, as in Example 1, and a redox dopant (2E,2'E,2"E)-2,2',2"-(cyclopropane-1,2,3-triylidene)tris(2-(2,3,5-trifluoro-6-(trifluoromethyl)pyridin-4-yl)acetonitrile (Dopant 2) in the weight ratio 98:2. The materials were co-deposited by vapor deposition. The layer thickness of the organic semiconductor layer was 50nm. The cross-talk currents were measured at 5 V on test layout for 40 μm channel which corresponds in this case to the pixel pitch. The comparative example 2 was not irradiated. The example 2.1 was irradiated with a pulse energy density of 4 $J/m^2$, the example 2.2 was irradiated with a pulse energy density of 5.5 $J/m^2$ and the example 2.3 was irradiated with a pulse energy density of 6 $J/m^2$ and the example 2.4 was irradiated with a pulse energy density of 6.5 $J/m^2$ Cross-talk current decreases significantly with pulse energy density showing a current reduction by more than a factor of 100 for example 2.3.

Example 3

The organic semiconductor layer 24 was a hole-injection layer (HIL), which comprises a hole transporting material N4,N4"-di(naphthalen-1-yl)-N4,N4"-diphenyl-[1,1':4',1"-terphenyl]-4,4"-diamine) (HTM2) and Dopant 2 in the weight ratio 96:4. The materials were co-deposited by vapor deposition. The layer thickness of the organic semiconductor layer was 50nm. The cross-talk currents were measured at 5 V on test layout for 40 μm channel which corresponds in this case to the pixel pitch. The comparative example 3 was not irradiated. The example 3.1 was irradiated with a pulse energy density of 4 $J/m^2$, the example 3.2 was irradiated with a pulse energy density of 5.5 $J/m^2$ and the example 3.3 was irradiated with a pulse energy density of 6 $J/m^2$ and the example 3.4 was irradiated with a pulse energy density of 6.5 $J/m^2$ Cross-talk current decreases significantly with pulse energy density showing a current reduction by more than a factor of 1000 for example 3.2.

Example 4

The organic semiconductor layer 24 was a hole-injection layer (HIL), which comprises a first organic layer comprising the compound Formula 3 and a second organic layer comprising the hole-transporting material HTM1. The materials were sequentially deposited by vapor deposition. The layer thickness of the first organic semiconductor layer was 10nm and the layer thickness of the second organic semiconductor layer was 120nm. The cross-talk currents were measured at 5 V on test layout for 40 μm channel which corresponds in this case to the pixel pitch. The comparative example 4 was not irradiated. The example 4.1 was irradiated with a pulse energy density of 4 $J/m^2$, the example 4.2 was irradiated with a pulse energy density of 5.5 $J/m^2$ and the example 4.3 was irradiated with a pulse energy density of 6 $J/m^2$ and the example 4.4 was irradiated with a pulse energy density of 6.5 $J/m^2$ Cross-talk current decreases significantly with pulse energy density showing a current reduction by more than a factor of 1000 for example 4.3.

Example 5

The organic semiconductor layer 24 was a electron-injection layer (EIL), which comprises an electron transporting material 3-Phenyl-3H-benzo[b]dinaphtho[2,1-d:1',2'-flphosphepine-3-oxide (ETM1) and the metal dopant Yb in the volume ratio 99:1. The materials were sequentially deposited by vapor deposition. The layer thickness of the first organic semiconductor layer was 50nm. The cross-talk currents were measured at 5 V on test layout for 40 μm channel which corresponds in this case to the pixel pitch. The comparative example 5 was not irradiated. The example 5.1 was irradiated with a pulse energy density of 4 $J/m^2$, the example 5.2 was irradiated with a pulse energy density of 5.5 $J/m^2$ and the example 5.3 was irradiated with a pulse energy density of 6 $J/m^2$ and the example 5.4 was irradiated with a pulse energy density of 6.5 $J/m^2$ Cross-talk current decreases significantly with pulse energy density showing a current reduction by more than a factor of 1000 for example 5.2.

Example 6

The organic semiconductor layer 24 was an electron-injection layer (EIL), which comprises an electron transporting material (ETM2) and the metal dopant Li in the volume ratio 99:1. The materials were sequentially deposited by vapor deposition. The layer thickness of the first organic semiconductor layer was 50nm. The cross-talk currents were measured at 5 V on test layout for 40 μm channel which corresponds in this case to the pixel pitch. The comparative example 6 was not irradiated. The example 6.1 was irradiated with a pulse energy density of 4 $J/m^2$, the example 6.2 was irradiated with a pulse energy density of 5.5 $J/m^2$ and the example 6.3 was irradiated with a pulse energy density of 6 $J/m^2$ and the example 6.4 was irradiated with a pulse energy density of 6.5 $J/m^2$ Cross-talk current decreases significantly with pulse energy density showing a current reduction by more than a factor of 1000 for example 6.2.

Table 2 shows the measured reduction in cross-talk currents at 5 V on test layout for 40 μm channel for Examples 2 to 6.

Table 2. Cross-talk current reduction on test layout for 40 μm channel at 5 V, current measured with S4200/robot. Examples 2 to 6

| Sample | Composition | Irradiation Pulse energy density | Pulse length | Cross-talk current reduction ratio $I_{after}/I_{before}$ |
|---|---|---|---|---|
| | | [J/cm$^2$] | [ms] | |
| Comparative example 2 | HTM1:Dopant2, 2 w%, 50 nm | 0 | 1 | 1/1 |
| Example 2.1 | HTM1:Dopant2, 2 w%, 50 nm | 4 | 1 | 1/1.1 |
| Example 2.2 | HTM1:Dopant2, 2 w%, 50 nm | 5.5 | 1 | 1/65 |
| Example 2.3 | HTM1:Dopant2, 2 w%, 50 nm | 6 | 1 | 1/457 |
| Example 2.4 | HTM1:Dopant2, 2 w%, 50 nm | 6.5 | 1 | 1/3489 |
| Comparative example 3 | HTM2:Dopant2, 4 w%, 50 nm | 0 | 1 | 1/1 |
| Example 3.1 | HTM2:Dopant2, 4 w%, 50 nm | 4 | 1 | 1/14.2 |
| Example 3.2 | HTM2:Dopant2, 4 w%, 50 nm | 5.5 | 1 | 1/4783 |
| Example 3.3 | HTM2:Dopant2, 4 w%, 50 nm | 6 | 1 | 1/5716 |
| Example 3.4 | HTM2:Dopant2, 4 w%, 50 nm | 6.5 | 1 | 1/5076 |
| Comparative example 4 | Compound of formula 3 50 nm / HTM1 120 nm | 0 | 1 | 1/2.6 |
| Example 4.1 | HTM2:Dopant 2, 4 vol%, 50 nm | 4 | 1 | 1/5.4 |
| Example 4.2 | HTM2:Dopant 2, 4 vol%, 50 nm | 5.5 | 1 | 1/52.1 |
| Example 4.3 | HTM2:Dopant 2, 4 vol%, 50 nm | 6 | 1 | 1/2954 |
| Example 4.4 | HTM2:Dopant 2, 4 vol%, 50 nm | 6.5 | 1 | 1/3383 |
| Comparative example 5 | ETM1:Yb, 1 vol%, 50 nm | 0 | 1 | 1/2.9 |
| Example 5.1 | ETM1:Yb, 1 vol%, 50 nm | 4 | 1 | 1/6.5 |
| Example 5.2 | ETM1:Yb, 1 vol%, 50 nm | 5.5 | 1 | 1/4445 |
| Example 5.3 | ETM1:Yb, | 6 | 1 | 1/5146 |
| | 1 vol%, 50 nm | | | |
| Example 5.4 | ETM1:Yb, 1 vol%, 50 nm | 6.5 | 1 | 1/6570 |
| Comparative example 6 | ETM2:Li, 1 vol%, 50 nm | 0 | 1 | 1/1.9 |
| Example 6.1 | ETM2:Li, 1 vol%, 50 nm | 4 | 1 | 1/151.2 |

(continued)

| Sample | Composition | Irradiation Pulse energy density | Pulse length | Cross-talk current reduction ratio $I_{after}/I_{before}$ |
|---|---|---|---|---|
| | | [J/cm$^2$] | [ms] | |
| Example 6.2 | ETM2:Li, 1 vol%, 50 nm | 5.5 | 1 | 1/116373 |
| Example 6.3 | ETM2:Li, 1 vol%, 50 nm | 6 | 1 | 1/96254 |
| Example 6.4 | ETM2:Li, 1 vol%, 50 nm | 6.5 | 1 | 1/74666 |

In summary, the desired reduction of conductivity of the organic semiconductor layer through irradiation treatment can be achieved for a wide range of compositions, including compositions suitable for hole injection and/or transport and for electron injection and/or transport.

Example 7

Photomasks are expensive and difficult to handle. Therefore, to mimic the effect of a photomask, a layer of 100 nm Al was deposited on top of the layer stack in the area above the first electrode. This layer is essentially opaque to light. The area above the light absorption layer was not covered by a layer of Al.

Fig. 6 shows a schematic view of the organic electronic device.

The organic electronic device comprises a substrate 60, a first electrode 61, a light absorption layer 62, a layer stack comprising the organic semiconductor layer 63 and a layer 64 of 100 nm Al on the pixel area. Irradiation 68 is applied to the device.

To demonstrate the technical effect of another embodiment of the invention, a 15Ω /cm$^2$ glass substrate with 90 nm ITO (available from Corning Co.) was cut to a size of 50 mm × 50 mm × 0.7 mm, ultrasonically cleaned with isopropyl alcohol for 5 minutes and then with pure water for 5 minutes, and cleaned again with UV ozone for 30 minutes, to prepare a first electrode. Then, the light absorption layer consisting of polyimide is deposited. Using photolithography, the light absorption layer is structured to form a grid with a pixel gap of 1.3 mm and a thickness of 1.5 μm.

Then, the layer stack is deposited using vacuum thermal evaporation, see Table 3. The layer stack comprised the organic semiconductor layer which may also be described as hole injection layer (HIL), a hole transport layer (HTL), an electron blocking layer (EBL), an emitting layer (EML), a hole blocking layer (HBL), an electron transport layer (ETL), a transparent cathode, and a capping layer. 100 nm of Al was deposited on top of the pixel area to mask this area from irradiation from the light source, see Fig. 6. The devices were finally encapsulated with a glass encapsulation. A robot was used to contact the electrodes.

Table 3. Layer stack used in example 7.

| **Layer** | **Materials** | **Thickness [nm]** |
|---|---|---|
| Anode | ITO | 90 |
| Organic semiconductor layer | HTM1 (92 wt.-%) doped with 4,4',4"-((1E,1'E,1"E)-cyclopropane-1,2,3-triylidenetris(cyanomethanylylidene))tris(2,3,5,6-tetrafluorobenzonitrile) (8 wt.-%) | 100 |
| HTL | HTM1 | 30 |
| EBL | N,N-bis(4-(dibenzo[b,d]furan-4-yl)phenyl)-[1,1':4',1"-terphenyl]-4-amine | 10 |
| EML | ABH113 (97 wt.-%) doped with BD200 (3 wt.-%) (available from Sun Fine Chemicals, Korea) | 25 |
| HBL | 2,4-diphenyl-6-(3'-(triphenylen-2-yl)-[1,1'-biphenyl]-3-yl)-1,3,5-triazine | 10 |
| ETL | ETM1 (99 wt.-%) doped with Yb(1 wt.-%) | 26 |
| Cathode | Ag | 15 |
| Cap layer | Biphenyl-4-yl(9,9-diphenyl-9H-fluoren-2-yl)-[4-(9-phenyl-9H-carbazol-3-yl) phenyl]-amine | 200 |

The currents were measured with a parameter analyzer Keithley S4200 as provided by Tektronix, Beaverton,

USA.

Table 4 shows the measured reduction in cross-talk currents at 5 V. The comparative example 7 was not irradiated. The example 7.1 was irradiated with a pulse energy density of 3 $J/cm^2$, the example 7.2 was irradiated with a pulse energy density of 3.5 $J/cm^2$. Cross-talk current decreases significantly for the examples 7.1 and 7.2 showing a current reduction by more than a factor of 1000.

Table 4. Cross-talk current reduction measured for example 7

| | Irradiation Pulse energy density | Pulse length | Cross-talk current reduction ratio $I_{after}/I_{before}$ |
|---|---|---|---|
| | [$J/cm^2$] | [ms] | |
| Comparative example 7 | 0 | 1 | 1/1 |
| Example 7.1 | 3 | 1 | 1/3681 |
| Example 7.2 | 3.5 | 1 | 1/4503 |

Fig. 7 shows the measured electrical and optical characteristics of example 7.2 before and after the exposure of the flash light irradiation as measured through the transparent bottom electrode.

In Fig. 7a the current density is shown versus voltage before and after irradiation treatment. As can be seen in Fig. 7a, the electrical properties are unchanged.

In Fig. 7b the quantum efficiency is shown versus current density before and after irradiation treatment. As can be seen in Fig. 7b, the optical properties are unchanged.

Surprisingly, the irradiation treatment does not cause any degradation in the areas which are not exposed to irradiation. This is very important, as it shows that the irradiation treatment of the present invention can be used for cross-talk reduction in high resolution devices, without risking degradation in areas which are not in a distance of 0 to 500 nm of the light absorption layer.

In summary, the method according to the present invention may be suitable to reduce the conductivity of an organic semiconductor layer in a fast and well-controlled manner, suitable for mass production.

The features disclosed in the foregoing description, in the claims and the accompanying drawings may, both separately and in any combination, be material for realizing the disclosed method in diverse forms thereof.

**Claims**

**1.** Method for preparing an organic electronic device comprising the steps:

a) providing a layer stack (10) applicable for preparing the organic electronic device, the layer stack comprising:

aa) a light absorption layer (32); and
bb) an organic semiconductor layer having a conductivity of at least $10^{-7}$ S/cm and a thickness of 0.1 to 100 nm;
wherein the distance between the organic semiconductor layer and the light absorption layer (32) is selected from 0 to 500 nm ;

b) providing a light source (11);
c) reducing the conductivity of the organic semiconductor layer by an irradiation treatment of the light absorption layer (32) by exposing it to light from the light source (11);
wherein the absorption of the light absorption layer (32) with respect to the light irradiated from the light source (11) is higher than the respective absorption of the organic semiconductor layer and wherein the conductivity of the organic semiconductor is essentially unchanged compared to the conductivity prior to the irradiation treatment in areas which are not arranged in the distance of 0 to 500 nm measured from the surface of the light absorption layer facing the organic semiconductor layer in the direction of the beam of the light source;
wherein the irradiation treatment is uniform with respect to a surface area of the layer stack (10) of at least 1 $cm^2$; and
the duration of the irradiation treatment is 10 ms or less and the energy density of the irradiation treatment is from 0.1 to 20 $J/cm^2$ at the position of the light absorption layer (32).

2. Method according to claim 1, wherein the organic semiconductor layer is arranged between the light source (11) and the light absorption layer (32).

3. Method according to claim 1 or 2, wherein the energy density of the light treatment is from 1 to 10 $J/cm^2$.

4. Method according to any of the preceding claims, wherein the light source (11) is selected from a gas discharge lamp, preferably xenon light source, or an LED light source or a laser light source.

5. Method according to any of the preceding claims, wherein the light treatment comprises a single light pulse or multiple light pulses.

6. Method according to any of the preceding claims, wherein the organic semiconductor layer comprises a redox-dopant.

7. Method according to any of the preceding claims, wherein the light absorption layer (32) comprises a photoresist compound.

8. Method according to any of the preceding claims, wherein the light absorption layer (32) is structured.

9. Method according to any of the preceding claims, wherein the light absorption layer (32) has a grid structure.

10. Method according to claim 9, wherein the layer stack further comprises a first electrode, the first electrode is structured to form a pixel electrode, and the first electrode structure constitutes a variety of pixels on the substrate having a pixel gap of less than 50 μm, alternatively from 0.1 μm to 30 μm, and a pixel pitch less than 150 μm, alternatively from 0.5 μm to 125 μm.

11. Organic electronic device obtainable by a method according to any of the preceding claims.

12. Organic electronic device according to claim 11, wherein the organic electronic device is an OLED, a photodetector, a transistor or a solar cell, preferably an OLED.

## Patentansprüche

1. Verfahren zur Herstellung einer organischen elektronischen Vorrichtung, umfassend die Schritte:

a) Bereitstellen eines Schichtstapels (10), der zur Herstellung der organischen elektronischen Vorrichtung verwendbar ist, wobei der Schichtstapel umfasst:

aa) eine Lichtabsorptionsschicht (32); und
bb) eine organische Halbleiterschicht mit einer Leitfähigkeit von mindestens $10^{-7}$ S/cm und einer Dicke von 0,1 bis 100 nm;

wobei der Abstand zwischen der organischen Halbleiterschicht und der Lichtabsorptionsschicht (32) zwischen 0 bis 500 nm ausgewählt ist;
b) Bereitstellen einer Lichtquelle (11);
c) Reduzieren der Leitfähigkeit der organischen Halbleiterschicht durch eine Bestrahlungsbehandlung der Lichtabsorptionsschicht (32), indem sie Licht von der Lichtquelle (11) ausgesetzt wird;
wobei die Absorption der Lichtabsorptionsschicht (32) in Bezug auf das von der Lichtquelle (11) abgestrahlte Licht höher ist als die jeweilige Absorption der organischen Halbleiterschicht und wobei die Leitfähigkeit des organischen Halbleiters im Wesentlichen unverändert ist im Vergleich zu der Leitfähigkeit vor der Bestrahlungsbehandlung in Bereichen, die nicht in dem Abstand von 0 bis 500 nm angeordnet sind, gemessen von der Oberfläche der Lichtabsorptionsschicht, die der organischen Halbleiterschicht in der Richtung des Strahls der Lichtquelle zugewandt ist;
wobei die Bestrahlungsbehandlung in Bezug auf einen Oberflächenbereich des Schichtstapels (10) von mindestens 1 $cm^2$ einheitlich ist; und
die Dauer der Bestrahlungsbehandlung 10 ms oder weniger beträgt und die Energiedichte der Bestrahlungsbehandlung von 0,1 bis 20 $J/cm^2$ an der Position der Lichtabsorptionsschicht (32) beträgt.

2. Verfahren nach Anspruch 1, wobei die organische Halbleiterschicht zwischen der Lichtquelle (11) und der Lichtabsorptionsschicht (32) angeordnet ist.

3. Verfahren nach Anspruch 1 oder 2, wobei die Energiedichte der Lichtbehandlung von 1 bis 10 J/cm2 beträgt.

4. Verfahren nach einem der vorhergehenden Ansprüche, wobei die Lichtquelle (11) aus einer Gasentladungslampe, vorzugsweise einer Xenonlichtquelle, oder einer LED-Lichtquelle oder einer Laserlichtquelle ausgewählt ist.

5. Verfahren nach einem der vorhergehenden Ansprüche, wobei die Lichtbehandlung einen einzelnen Lichtimpuls oder mehrere Lichtimpulse umfasst.

6. Verfahren nach einem der vorhergehenden Ansprüche, wobei die organische Halbleiterschicht einen Redoxdotierstoff umfasst.

7. Verfahren nach einem der vorhergehenden Ansprüche, wobei die Lichtabsorptionsschicht (32) eine Photoresistverbindung umfasst.

8. Verfahren nach einem der vorhergehenden Ansprüche, wobei die Lichtabsorptionsschicht (32) strukturiert ist.

9. Verfahren nach einem der vorhergehenden Ansprüche, wobei die Lichtabsorptionsschicht (32) eine Gitterstruktur aufweist.

10. Verfahren nach Anspruch 9, wobei der Schichtstapel ferner eine erste Elektrode umfasst, die erste Elektrode strukturiert ist, um eine Pixelelektrode zu bilden, und die erste Elektrodenstruktur eine Vielfalt von Pixeln auf dem Substrat mit einer Pixellücke von weniger als 50 $\mu$m, alternativ von 0,1 $\mu$m bis 30 $\mu$m, und einem Pixelabstand von weniger als 150 $\mu$m, alternativ von 0,5 $\mu$m bis 125 $\mu$m, darstellt.

11. Organische elektronische Vorrichtung, die durch ein Verfahren nach einem der vorhergehenden Ansprüche erhältlich ist.

12. Organische elektronische Vorrichtung nach Anspruch 11, wobei die organische elektronische Vorrichtung eine OLED, ein Fotodetektor, ein Transistor oder eine Solarzelle, vorzugsweise eine OLED, ist.

## Revendications

1. Procédé de préparation d'un dispositif électronique organique, comprenant les étapes suivantes :

a) la fourniture d'une pile de couches (10) applicable pour préparer le dispositif électronique organique, la pile de couches comprenant :

aa) une couche d'absorption de lumière (32) ; et
bb) une couche de semi-conducteur organique présentant une conductivité d'au moins $10^{-7}$ S/cm et une épaisseur de 0,1 à 100 nm ;

dans lequel la distance entre la couche de semi-conducteur organique et la couche d'absorption de lumière (32) est sélectionnée dans une plage de 0 à 500 nm ;
b) la fourniture d'une source de lumière (11) ;
c) la réduction de la conductivité de la couche de semi-conducteur organique par un traitement d'irradiation de la couche d'absorption de lumière (32) en l'exposant à la lumière de la source de lumière (11) ;
dans lequel l'absorption de la couche d'absorption de lumière (32) par rapport à la lumière irradiée par la source de lumière (11) est supérieure à l'absorption respective de la couche de semi-conducteur organique, et dans lequel la conductivité du semi-conducteur organique est essentiellement inchangée par rapport à la conductivité avant le traitement d'irradiation dans des zones qui ne sont pas agencées à une distance de 0 à 500 nm mesurée depuis la surface de la couche d'absorption de lumière qui fait face à la couche de semi-conducteur organique en direction du faisceau de la source de lumière ;
dans lequel le traitement d'irradiation est uniforme par rapport à une superficie de la pile de couches (10) d'au moins 1 $cm^2$ ; et

la durée du traitement d'irradiation est inférieure ou égale à 10 ms et la densité d'énergie du traitement d'irradiation est comprise entre 0,1 et 20 J/cm$^2$ à la position de la couche d'absorption de lumière (32).

**2.** Procédé selon la revendication 1, dans lequel la couche de semi-conducteur organique est agencée entre la source de lumière (11) et la couche d'absorption de lumière (32).

**3.** Procédé selon la revendication 1 ou 2, dans lequel la densité d'énergie du traitement lumineux est comprise entre 1 et 10 J/cm$^2$.

**4.** Procédé selon l'une quelconque des revendications précédentes, dans lequel la source de lumière (11) est sélectionnée parmi une lampe à décharge, et préférablement une source de lumière à xénon, une source de lumière à diodes électroluminescentes LED, ou une source de lumière laser.

**5.** Procédé selon l'une quelconque des revendications précédentes, dans lequel le traitement lumineux comprend une impulsion lumineuse unique ou des impulsions lumineuses multiples.

**6.** Procédé selon l'une quelconque des revendications précédentes, dans lequel la couche de semi-conducteur organique comprend un dopant redox.

**7.** Procédé selon l'une quelconque des revendications précédentes, dans lequel la couche d'absorption de lumière (32) comprend un composé à résine photosensible.

**8.** Procédé selon l'une quelconque des revendications précédentes, dans lequel la couche d'absorption de lumière (32) est structurée.

**9.** Procédé selon l'une quelconque des revendications précédentes, dans lequel la couche d'absorption de lumière (32) présente une structure de grille.

**10.** Procédé selon la revendication 9, dans lequel la pile de couches comprend en outre une première électrode, la première électrode est structurée pour former une électrode de pixel, et la première structure d'électrode constitue une variété de pixels sur le substrat ayant un intervalle de pixels inférieur à 50 $\mu$m, en variante de 0,1 $\mu$m à 30 $\mu$m, et un pas de pixels inférieur à 150 $\mu$m, en variante de 0,5 $\mu$m à 125 $\mu$m.

**11.** Dispositif électronique organique obtenable par un procédé selon l'une quelconque des revendications précédentes.

**12.** Dispositif électronique organique selon la revendication 11, dans lequel le dispositif électronique organique est une diode électroluminescente organique OLED, un photodétecteur, un transistor ou une cellule photovoltaïque, préférablement de type OLED.

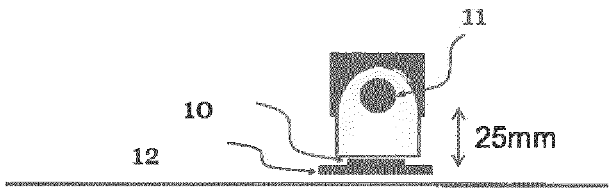


**Fig. 1**

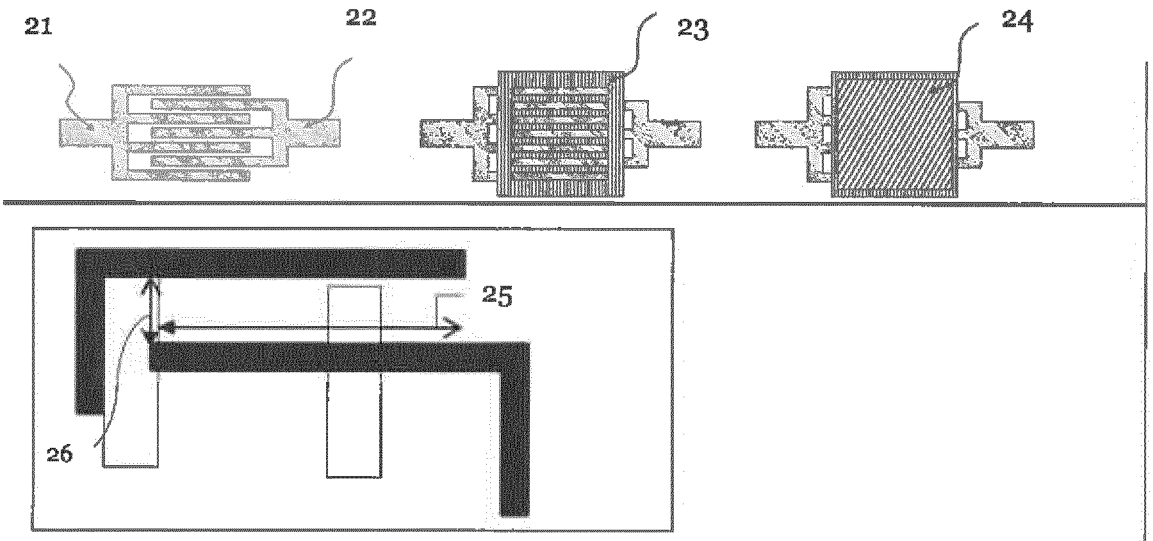


**Fig. 2**

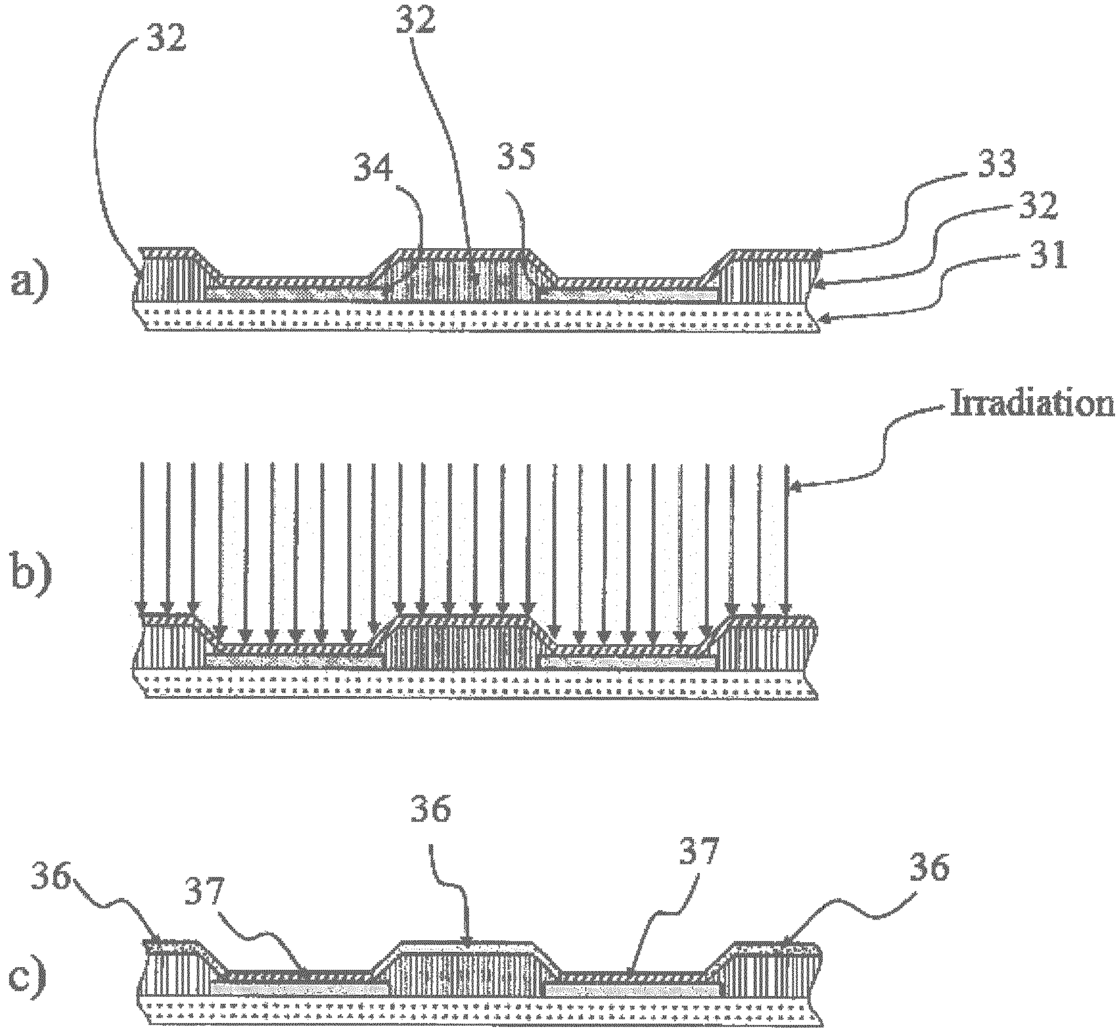


Fig. 3a

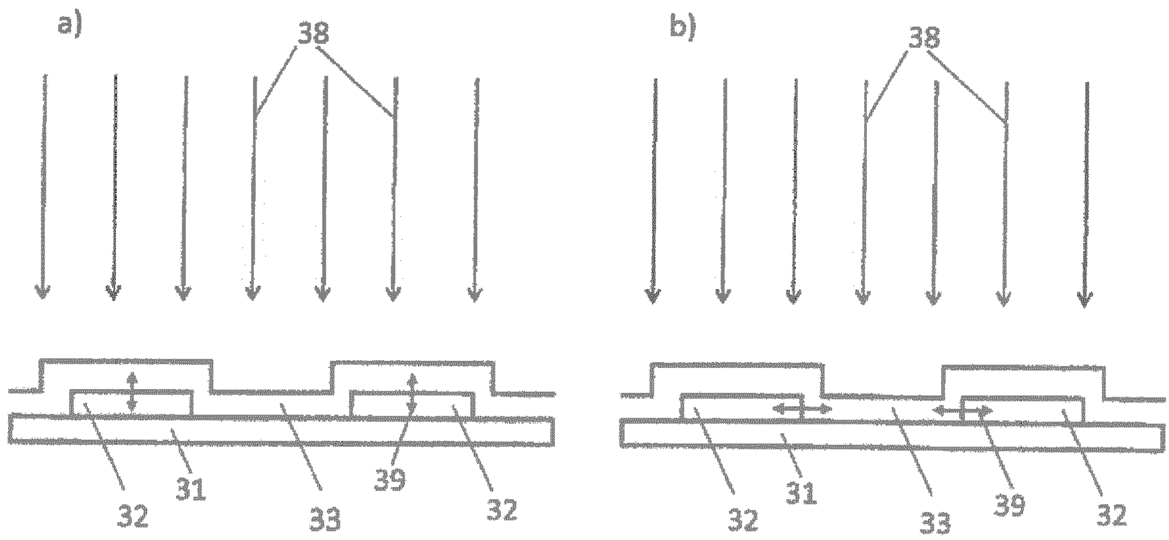


Fig. 3b

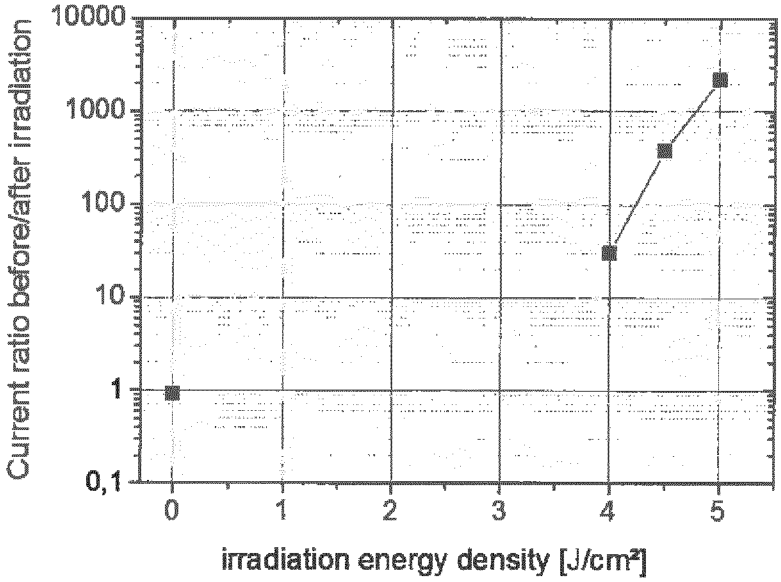
Current ratio before/after irradiation
10000
1000
100
10
1
0,1
0
1
2
3
4
5
irradiation energy density [J/cm²]

Fig. 4

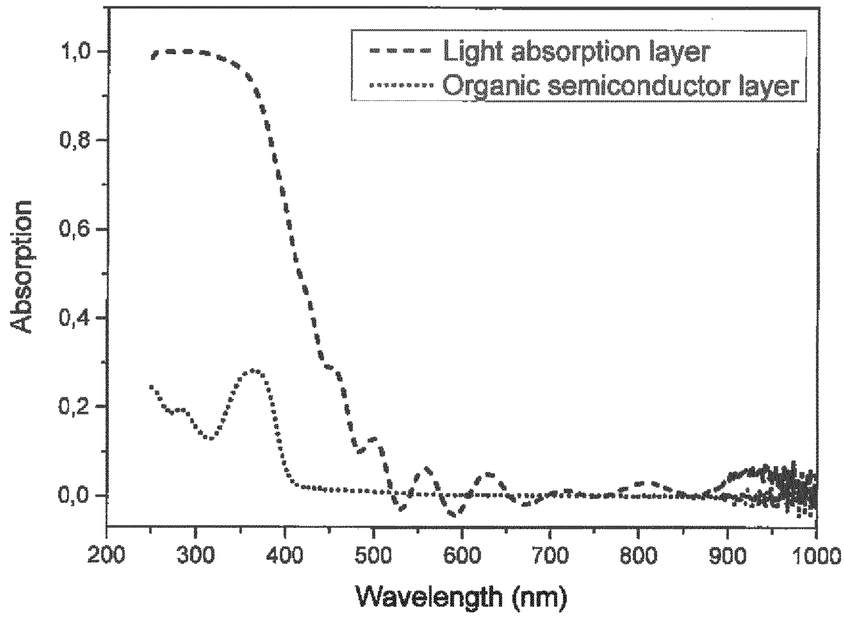
Light absorption layer
Organic semiconductor layer
Absorption
1,0
0,8
0,6
0,4
0,2
0,0
200
300
400
500
600
700
800
900
1000
Wavelength (nm)

Fig. 5

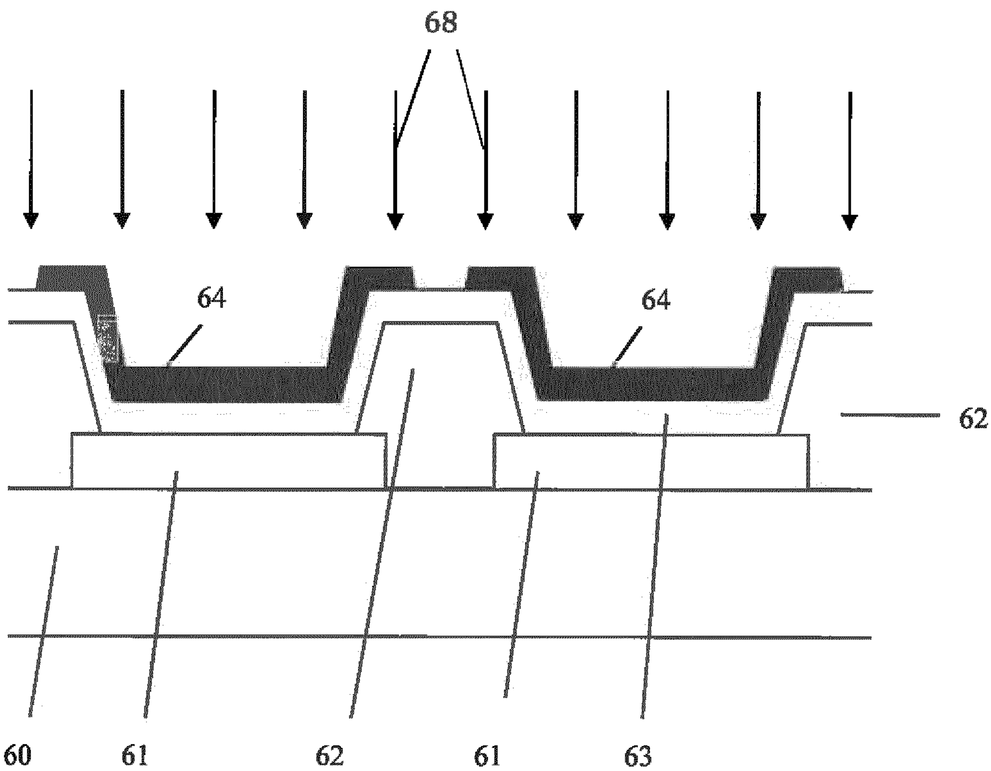
68
64
64
62
60
61
62
61
63

Fig. 6

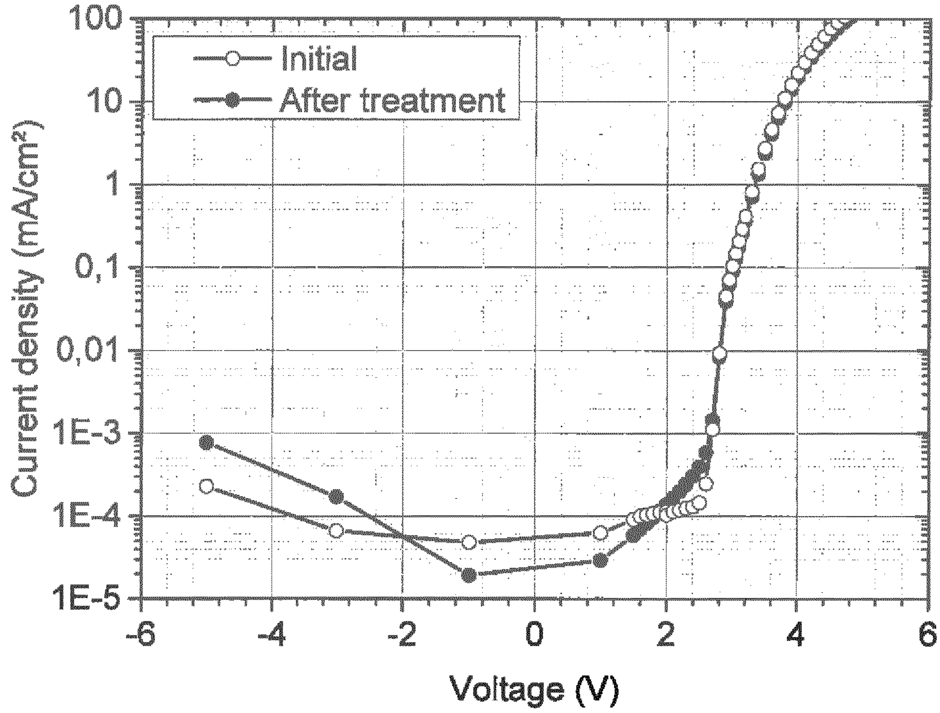


Fig. 7a

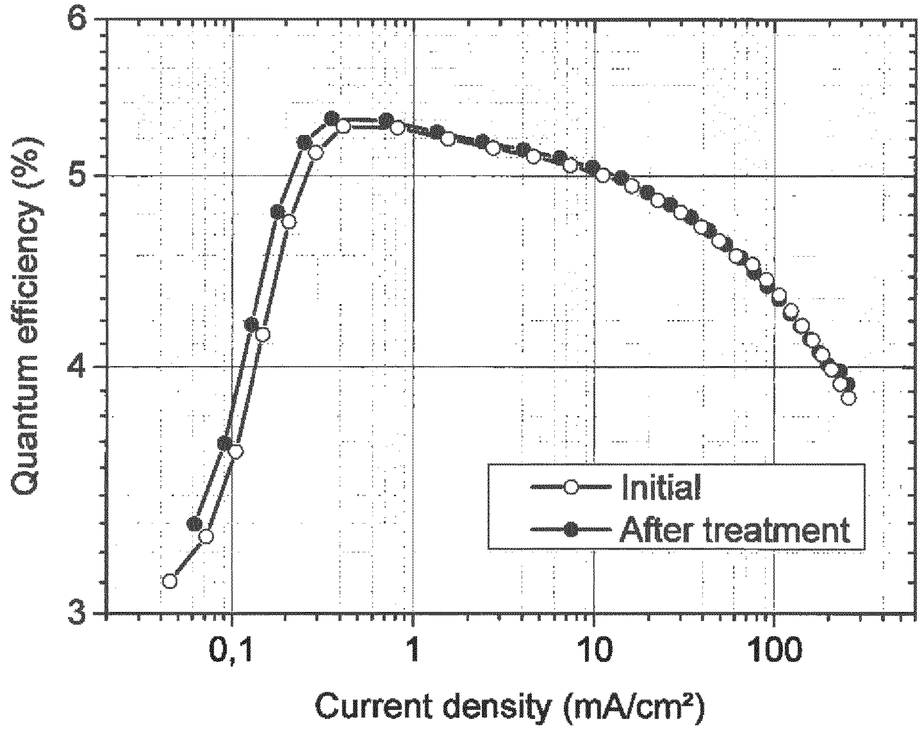


Fig. 7b

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2008100204 A
- US 2013295715 A1
- WO 2012133203 A1
- US 2016211461 A1
- JP 3849726 B
- JP 2002110345 A
- US 2005247946 A
- US 2013110421 A
- EP 2722908 A1
- US 2012098012 A

### Non-patent literature cited in the description

- **PARISSE et al.** *Organic electronics,* 2006, vol. 7 (5), 403-409
- **DK SCHRODER.** Semiconductor material and device characterization. Wiley, 1990
- **Y. SHIROTA ; H. KAGEYAMA.** *Chem. Rev.,* 2007, vol. 107, 953-1010
- **YASUHIKO SHIROTA ; HIROSHI KAGEYAMA.** *Chem. Rev.,* 2007, vol. 107, 953-1010